# EUROPEAN PATENT APPLICATION

(11) **EP 4 618 415 A1**
(43) Date of publication of application: **17.09.2025**
(21) Application number: 22967530.1
(22) Date of filing: 06.12.2022
(51) Int. Cl.: H03H 11/16

(54) **PHASE SHIFTING CIRCUIT, ANTENNA FEED SYSTEM AND COMMUNICATION DEVICE**

(71) Applicant: Huawei Technologies Co., Ltd., Shenzhen, Guangdong 518129 (CN)
(72) Inventor: WU, Xipeng, Shenzhen, Guangdong 518129 (CN); YUAN, Peng, Shenzhen, Guangdong 518129 (CN); JIANG, Xiangzhong, Shenzhen, Guangdong 518129 (CN); YAO, Xin, Shenzhen, Guangdong 518129 (CN); CHEN, Hongsu, Shenzhen, Guangdong 518129 (CN); GUO, Caibiao, Shenzhen, Guangdong 518129 (CN); FENG, Yun, Shenzhen, Guangdong 518129 (CN); WAN, Jinju, Shenzhen, Guangdong 518129 (CN)
(74) Representative: Pfenning, Meinig & Partner mbB
(86) International application number: PCT/CN2022/136907
(87) International publication number: WO 2024/119368

(57) **Abstract**

This application provides a phase shift circuit, an antenna system, and a communication device. The phase shift circuit includes an input end, an output end, a phase lead branch circuit, and a phase lag branch circuit. The phase lead branch circuit and the phase lag branch circuit are connected in parallel between the input end and the output end. The phase lead branch circuit includes a first radio frequency switch unit and a phase lead unit. The first radio frequency switch unit and the phase lead unit are connected in series between the input end and the output end. The phase lag branch circuit includes a first phase lag unit, a second phase lag unit, and a second radio frequency switch unit. The first phase lag unit and the second phase lag unit are connected in series between the input end and the output end, and the second radio frequency switch unit is connected between the ground and a first connection point between the first phase lag unit and the second phase lag unit. According to this application, a volume occupied by the phase shift circuit can be reduced, costs are low, a power capacity and a linear indicator of the phase shift circuit are improved, and an insertion loss is small.

## Description

### TECHNICAL FIELD

This application relates to the field of wireless communication technologies, and in particular, to a phase shift circuit, an antenna system, and a communication device.

### BACKGROUND

In a wireless communication technology, a beamforming technology is usually used to improve a communication capacity and communication quality. The beamforming technology is to concentrate energy in a specific direction by controlling a relative delay and an amplitude between electromagnetic waves transmitted by a wave source, and a radio signal is propagated in the specific direction in a form of an electromagnetic wave.

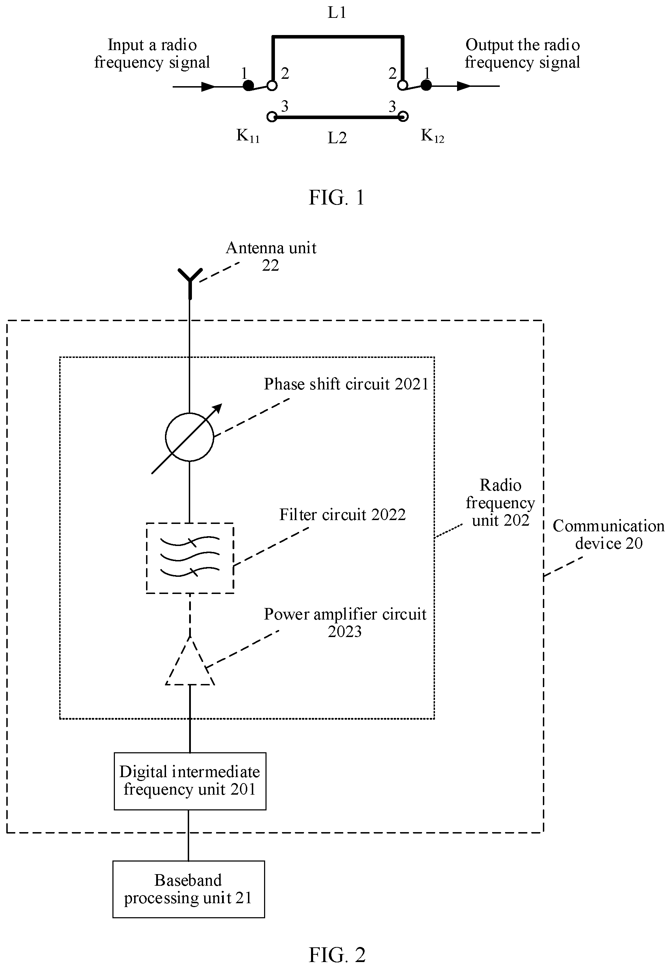

In a specific implementation, the relative delay between the electromagnetic waves transmitted by the wave source may be controlled by using a phase shift circuit. For example, in an existing phase shift circuit shown in FIG. 1, L1 and L2 are two transmission lines respectively. When a radio frequency signal passes through a transmission line with a specific length, a phase lag occurs. In addition, when passing through transmission lines with different lengths, a same radio frequency signal has different phase lag degrees. If a contact 1 of a switch *K*₁₁ is in contact with a contact 2, and a contact 1 of a switch *K*₁₂ is in contact with a contact 2, a phase of the radio frequency signal passing through the transmission line L1 lags by *φ*₁. Alternatively, if a contact 1 of a switch *K*₁₁ is in contact with a contact 3, and a contact 1 of a switch *K*₁₂ is in contact with a contact 3, a phase of the radio frequency signal passing through the transmission line L2 lags by *φ*₂. In this case, the switch *K*₁₁ and the switch *K*₁₂ are switched between two states that the contact 1 is in contact with the contact 2 and the contact 1 is in contact with the contact 3. The phase shift circuit shown in FIG. 1 may implement a phase shift amount Δ*φ* = *φ*₁ - *φ*₂*.* A radio frequency signal output by the phase shift circuit is converted into an electromagnetic wave via an antenna unit and transmitted, and a propagation direction of the electromagnetic wave is related to the phase shift amount Δ*φ.*

The phase shift circuit switches a transmission path of a radio frequency signal by switching a state of a switch element, and implements phase shift of the radio frequency signal based on a difference between lagging phases of the radio frequency signal on different transmission paths. A phase shift amount of the phase shift circuit is related to a phase lag amount. In the phase shift circuit shown in FIG. 1, a larger phase shift amount indicates a larger phase lag amount that needs to be implemented on each transmission path, and a larger phase lag amount indicates a larger length of a transmission line, causing a larger volume occupied by the phase shift circuit. Therefore, how to reduce a volume occupied by a phase shift circuit while ensuring that a same phase shift amount is obtained is a key problem to be researched.

### SUMMARY

Embodiments of this application provide a phase shift circuit, an antenna system, and a communication device. On the basis of obtaining a same phase shift amount, a volume occupied by the phase shift circuit can be reduced, a power capacity of the phase shift circuit can be improved, a linear indicator of the phase shift circuit is improved, costs are low, and an insertion loss is small.

According to a first aspect, an embodiment of this application provides a phase shift circuit. The phase shift circuit includes an input end, an output end, a phase lead branch circuit, and a phase lag branch circuit. The phase lead branch circuit and the phase lag branch circuit are connected in parallel between the input end and the output end.

In a specific implementation, the phase lead branch circuit includes a first radio frequency switch unit and a phase lead unit, and the first radio frequency switch unit and the phase lead unit are connected in series between the input end and the output end. The phase lag branch circuit includes a first phase lag unit, a second phase lag unit, and a second radio frequency switch unit. The first phase lag unit and the second phase lag unit are connected in series between the input end and the output end. A first connection point between the first phase lag unit and the second phase lag unit is connected to one end of the second radio frequency switch unit, and the other end of the second radio frequency switch unit is grounded.

An implementation principle of this embodiment of this application is as follows: When the first radio frequency switch unit and the second radio frequency switch unit are in an on state, a phase lead is obtained, to be specific, a phase of a radio frequency signal output by the output end leads a phase of a radio frequency signal input by the input end. When the first radio frequency switch unit and the second radio frequency switch unit are in an off state, a phase lag is obtained, to be specific, the phase of the radio frequency signal output by the output end lags behind the phase of the radio frequency signal input by the input end. It should be explained that, in this embodiment of this application, the phase lead may be obtained by using the phase lead branch circuit. Therefore, when a phase shift amount that is the same as that of an existing phase shift circuit is obtained, a phase lag amount that needs to be implemented by the phase lag branch circuit may be reduced, to reduce a length of a transmission line in a phase lag unit, and further reduce a volume occupied by the phase shift circuit. In addition, the volume occupied by the phase shift circuit is reduced, and a volume of a printed circuit board (Printed Circuit Board, PCB) on which the phase shift circuit is etched may also be reduced, to reduce material costs.

With reference to the first aspect, in a first possible implementation, the phase lead unit includes a first inductive unit. The first inductive unit and the first radio frequency switch unit are connected in series between the input end and the output end.

With reference to the first aspect, in a second possible implementation, the phase lead unit includes a first capacitive unit. The first capacitive unit and the first radio frequency switch unit are connected in series between the input end and the output end.

With reference to the second possible implementation of the first aspect, in a third possible implementation, the phase lead unit further includes a second inductive unit. One end of the second inductive unit is connected to a second connection point, and the other end of the second inductive unit is grounded. The second connection point is a connection point between the first radio frequency switch unit and the first capacitive unit. According to this embodiment of this application, a phase lead amount of the phase lead unit may be further increased.

With reference to the second possible implementation of the first aspect or the third possible implementation of the first aspect, in a fourth possible implementation, the phase lead branch circuit further includes a third inductive unit. The third inductive unit and the first capacitive unit are connected in parallel. In this embodiment of this application, the third inductive unit is added, and the third inductive unit and a capacitive unit in the phase lead unit form LC resonance. Therefore, a low frequency signal outside a primary operating frequency band can be suppressed, low frequency non-linear products generated by the phase shift circuit are reduced, and impact of the phase shift circuit on another communication device is avoided.

With reference to the first aspect or any one of the foregoing possible implementations of the first aspect, in a fifth possible implementation, the phase lag branch circuit further includes a third phase lag unit.

The first connection point between the first phase lag unit and the second phase lag unit is connected to one end of the second radio frequency switch unit, and the other end of the second radio frequency switch unit is grounded. Specifically, the third phase lag unit and the second radio frequency switch unit are connected in series between the first connection point and the ground. The first phase lag unit, the second phase lag unit, and the third phase lag unit in this embodiment of this application jointly implement a phase lag, so that the volume occupied by the phase shift circuit can be further reduced.

With reference to the fifth possible implementation of the first aspect, in a sixth possible implementation, the phase lag branch circuit further includes a second capacitive unit.

The third phase lag unit and the second radio frequency switch unit are connected in series between the first connection point and the ground. Details are as follows:

The second capacitive unit, the third phase lag unit, and the second radio frequency switch unit are connected in series between the first connection point and the ground. In this embodiment of this application, the second capacitive unit may further reduce a voltage that needs to be borne by two ends of the second radio frequency switch unit.

With reference to the sixth possible implementation of the first aspect, in a seventh possible implementation, the phase lag branch circuit further includes a fourth inductive unit. The fourth inductive unit and the second capacitive unit are connected in parallel. In this embodiment of this application, the fourth inductive unit is added, and the fourth inductive unit and a capacitive unit in the phase lag unit form LC resonance. Therefore, a low frequency signal outside a primary operating frequency band can be suppressed, low frequency non-linear products generated by the phase shift circuit are reduced, and impact of the phase shift circuit on another communication device is avoided.

With reference to the first aspect, or with reference to the first possible implementation of the first aspect to the fourth possible implementation of the first aspect, in an eighth possible implementation, the phase lag branch circuit further includes a third capacitive unit.

The first connection point between the first phase lag unit and the second phase lag unit is connected to one end of the second radio frequency switch unit, and the other end of the second radio frequency switch unit is grounded. Specifically, the third capacitive unit and the second radio frequency switch unit are connected in series between the first connection point and the ground. In this embodiment of this application, the third capacitive unit may further reduce a voltage that needs to be borne by two ends of the second radio frequency switch unit.

With reference to the eighth possible implementation of the first aspect, in a ninth possible implementation, the phase lag branch circuit further includes a fifth inductive unit. The fifth inductive unit and the third capacitive unit are connected in parallel. In this embodiment of this application, the fifth inductive unit is added, and the fifth inductive unit and a capacitive unit in the phase lag unit form LC resonance. Therefore, a low frequency signal outside a primary operating frequency band can be suppressed, low frequency non-linear products generated by the phase shift circuit are reduced, and impact of the phase shift circuit on another communication device is avoided.

According to a second aspect, an embodiment of this application provides an antenna system. The antenna system includes an antenna unit and the phase shift circuit with reference to the first aspect or any one of the foregoing possible implementations of the first aspect, and the phase shift circuit is connected to the antenna unit.

According to a third aspect, an embodiment of this application provides a communication device. The communication device includes a digital intermediate frequency unit, a radio frequency unit connected to the digital intermediate frequency unit, and an antenna unit. The radio frequency unit includes the phase shift circuit with reference to the first aspect or any one of the foregoing possible implementations of the first aspect, and the phase shift circuit is connected to the antenna unit.

It should be understood that mutual reference may be made to the implementations and beneficial effects of the foregoing aspects of this application.

### BRIEF DESCRIPTION OF DRAWINGS

FIG. 1 shows a phase shift circuit according to the conventional technology;
FIG. 2 is a diagram of a structure of a communication device according to an embodiment of this application;
FIG. 3 is a diagram of another structure of a communication device according to an embodiment of this application;
FIG. 4 is a diagram of another structure of a communication device according to an embodiment of this application;
FIG. 5 is a diagram of a structure of an antenna system according to an embodiment of this application;
FIG. 6 is a diagram of another structure of an antenna system according to an embodiment of this application;
FIG. 7 is a block diagram of a circuit structure of a phase shift circuit according to an embodiment of this application;
FIG. 8 is a diagram of a radio frequency signal according to an embodiment of this application;
FIG. 9A to FIG. 9H are circuit diagrams of phase lead units according to an embodiment of this application;
FIG. 10 to FIG. 16 each are a block diagram of another circuit structure of a phase shift circuit according to an embodiment of this application; and
FIG. 17A to FIG. 17K are circuit diagrams of phase lag units according to an embodiment of this application.

### DESCRIPTION OF EMBODIMENTS

Technical solutions in embodiments of this application are clearly and completely described below with reference to the accompanying drawings in embodiments of this application. It is clear that, the described embodiments are merely some rather than all of embodiments of this application. All other embodiments obtained by a person of ordinary skill in the art based on embodiments of this application without creative efforts shall fall within the protection scope of this application.

Implementations of the technical solutions of this application are further described below in detail with reference to the accompanying drawings.

FIG. 2 is a diagram of a structure of a communication device according to an embodiment of this application. As shown in FIG. 2, the communication device 20 is connected to a baseband processing unit 21 via an optical fiber. The baseband processing unit 21 may be referred to as a BBU (Baseband Unit), and the BBU may implement baseband processing functions, for example, encoding, multiplexing, modulation, and spreading.

The communication device 20 is connected to an antenna unit 22 via a feeder. The antenna unit 22 includes at least one antenna element.

An optical signal is transmitted in the optical fiber, in other words, the optical signal is transmitted between the baseband processing unit 21 and the communication device 20. An electrical signal is transmitted in the feeder, in other words, the electrical signal is transmitted between the communication device 20 and the antenna unit 22.

The communication device 20 includes a digital intermediate frequency unit 201 and a radio frequency unit 202 connected to the digital intermediate frequency unit 201. The baseband processing unit 21 is specifically connected to the digital intermediate frequency unit 201 in the communication device 20. The digital intermediate frequency unit 201 is configured to perform modulation and demodulation, digital up/down-conversion, signal clipping, analog-to-digital conversion, and the like for optical transmission.

The radio frequency unit 202 includes a phase shift circuit 2021, and the phase shift circuit 2021 may perform phase shift on a radio frequency signal in the radio frequency unit 202.

In some feasible implementations, the radio frequency unit 202 further includes a filter circuit 2022, and the filter circuit 2022 is located between the phase shift circuit 2021 and the digital intermediate frequency unit 201. The filter circuit 2022 may perform frequency selection on the radio frequency signal in the radio frequency unit 202, to filter out an interference frequency band of the radio frequency signal in the radio frequency unit 202.

Further, the radio frequency unit 202 further includes a power amplifier circuit 2023. The power amplifier circuit 2023 is located between the filter circuit 2022 and the digital intermediate frequency unit 201, and may perform power amplification on a radio frequency signal. In this case, the digital intermediate frequency unit 201 is specifically connected to the power amplifier circuit 2023 in the radio frequency unit 202.

For example, the communication device 20 sends a signal. The digital intermediate frequency unit 201 modulates a baseband signal sent by the baseband processing unit 21, to obtain a first radio frequency signal. The first radio frequency signal is amplified by the power amplifier circuit 2023 and then transmitted to the filter circuit 2022. The filter circuit 2022 filters out an interference frequency band, to obtain a second radio frequency signal. Phase shift is performed on the second radio frequency signal by the phase shift circuit 2021, to obtain a third radio frequency signal, and the third radio frequency signal is converted into an electromagnetic wave by using the antenna unit 22 and transmitted.

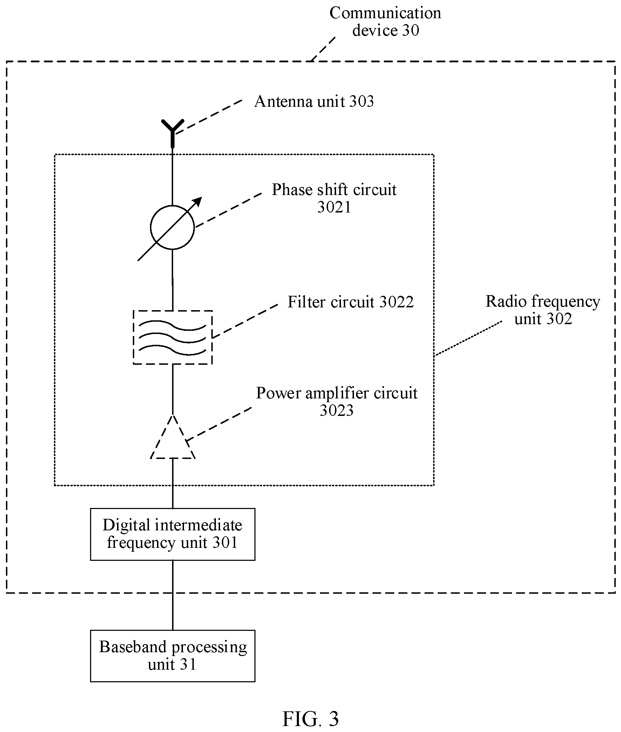

In some feasible implementations, an antenna unit may be further disposed in a communication device. FIG. 3 is a diagram of another structure of a communication device according to an embodiment of this application. As shown in FIG. 3, a difference between the communication device 30 and the communication device 20 lies in that, in addition to a digital intermediate frequency unit 301 and a radio frequency unit 302, the communication device 30 further includes an antenna unit 303. The antenna unit 303 includes at least one antenna element. In addition, each antenna element in the antenna unit 303 is specifically connected to one end of a phase shift circuit 3021 in the radio frequency unit 302, the other end of the phase shift circuit 3021 is connected to one end of a power amplifier circuit 3023 by using a filter circuit 3022, the other end of the power amplifier circuit 3023 is connected to one end of the digital intermediate frequency unit 301, and the other end of the digital intermediate frequency unit 301 is connected to a baseband processing unit 31. It may be understood that, for a specific implementation of the communication device 30, refer to a specific implementation of the communication device 20. Details are not described herein again.

In this embodiment of this application, an antenna unit is integrated into a communication device, and the communication device may be understood as an active antenna unit (Active Antenna Unit, AAU). According to this embodiment of this application, cable connections between the communication device and the antenna unit can be reduced, and costs are low. In addition, the communication device and the antenna unit are integrated together, so that integration is high and space utilization is high.

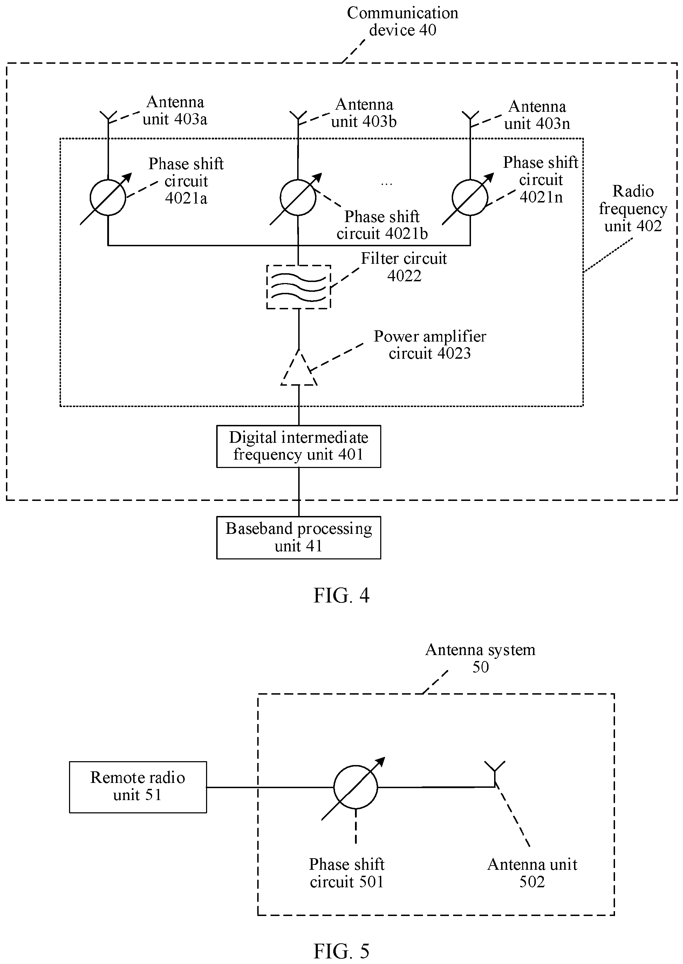

In some feasible implementations, a plurality of antenna units may be disposed in the communication device, and phase shift circuits corresponding to the antenna units are disposed in the radio frequency unit. In this case, the communication device may be shown in FIG. 4. The communication device 40 includes a digital intermediate frequency unit 401 and a radio frequency unit 402. The radio frequency unit 402 includes a phase shift circuit 4021a, a phase shift circuit 4021b, and a phase shift circuit 4021n. One end of the phase shift circuit 4021a is connected to an antenna unit 403a, one end of the phase shift circuit 4021b is connected to an antenna unit 403b, one end of the phase shift circuit 4021n is connected to an antenna unit 403n, and the other end of the phase shift circuit 4021a, the other end of the phase shift circuit 4021b, and the other end of the phase shift circuit 4021n are connected to one end of a filter circuit 4022. The filter circuit 4022 is connected to one end of the digital intermediate frequency unit 401 by using a power amplifier circuit 4023, and the other end of the digital intermediate frequency unit 401 is connected to a baseband processing unit 41. A difference from the communication device 30 lies in that, the plurality of antenna units in the communication device 40 provided in this embodiment of this application share one baseband processing unit 41. A baseband signal transmitted by the baseband processing unit 41 is modulated by the digital intermediate frequency unit 401, to obtain a fourth radio frequency signal. The fourth radio frequency signal is transmitted to the phase shift circuits by using the power amplifier circuit 4023 and the filter circuit 4022. Phase shift amounts of the phase shift circuits may be different, so that electromagnetic waves propagated in different directions by the antenna units connected to the phase shift circuits are obtained.

For example, the antenna unit 403a, the antenna unit 403b, and the antenna unit 403n each include at least one antenna element. Further, one antenna array may include the antenna unit 403a, the antenna unit 403b, and the antenna unit 403n. In this case, the antenna unit 403a, the antenna unit 403b, and the antenna unit 403n may be disposed on a same PCB.

In this embodiment of this application, the plurality of antenna units and the plurality of phase shift circuits are integrated into the communication device, so that integration is higher and space utilization is higher.

It should be noted that the communication device provided in this application may be used in scenarios such as a base station, a terminal device, a radar, and wireless fidelity (Wireless Fidelity, Wi-Fi). The terminal device may be, for example, an intelligent wearable device, a smartphone, a tablet computer, a notebook computer, a vehicle-mounted computer, a server, or an intelligent vehicle. A specific implementation of the terminal device is not limited in this embodiment of this application.

In some feasible implementations, in addition to the communication device, a product form that may be specifically implemented in this application may be further implemented as an antenna system. For example, FIG. 5 is a diagram of a structure of an antenna system according to an embodiment of this application. As shown in FIG. 5, the antenna system 50 is connected to a remote radio unit 51. The remote radio unit 51 may be referred to as an RRU (Remote Radio Unit).

The antenna system 50 includes a phase shift circuit 501 and an antenna unit 502. The phase shift circuit 501 is connected to the antenna unit 502. For example, the phase shift circuit 501 performs phase shift on a fifth radio frequency signal provided by the remote radio unit 51, to obtain a sixth radio frequency signal. The antenna unit 502 converts the sixth radio frequency signal into an electromagnetic wave, and the electromagnetic wave is propagated in a specific direction, to implement signal transmission.

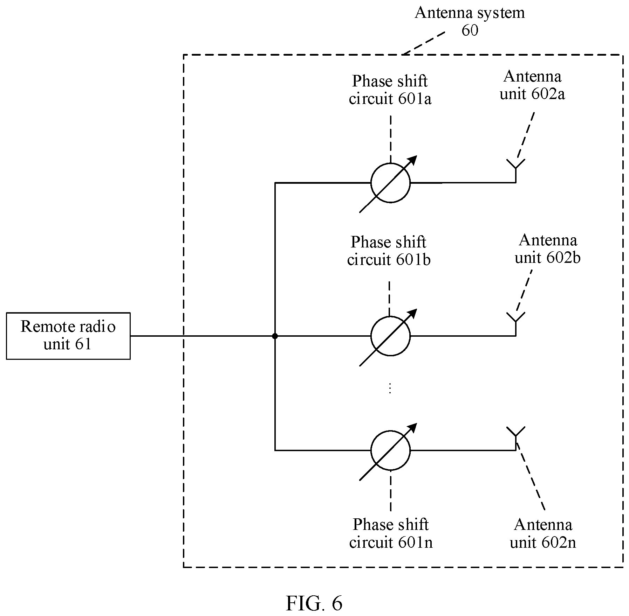

Similarly, an antenna system may alternatively include a plurality of phase shift circuits and antenna units connected to the phase shift circuits. FIG. 6 is a diagram of another structure of an antenna system according to an embodiment of this application. As shown in FIG. 6, the antenna system 60 is connected to a remote radio unit 61. The remote radio unit 61 may be referred to as an RRU (Remote Radio Unit).

The antenna system 60 includes a phase shift circuit 601a, a phase shift circuit 601b, and a phase shift circuit 601n. The remote radio unit 61 is specifically connected to one end of the phase shift circuit 601a, one end of the phase shift circuit 601b, and one end of the phase shift circuit 601n in the antenna system 60, the other end of the phase shift circuit 601a is connected to an antenna unit 602a, the other end of the phase shift circuit 601b is connected to an antenna unit 602b, and the other end of the phase shift circuit 601n is connected to an antenna unit 602n. In this case, the plurality of phase shift circuits and the plurality of antenna units are integrated together, so that integration is high and space utilization is high. For a specific implementation, refer to the antenna system 50. Details are not described herein again.

For example, the antenna unit 602a, the antenna unit 602b, and the antenna unit 602n each include at least one antenna element. Further, one antenna array may include the antenna unit 602a, the antenna unit 602b, and the antenna unit 602n. In this case, the antenna unit 602a, the antenna unit 602b, and the antenna unit 602n may be disposed on a same PCB.

The following describes a specific structure of a phase shift circuit provided in an embodiment of this application with reference to the accompanying drawings.

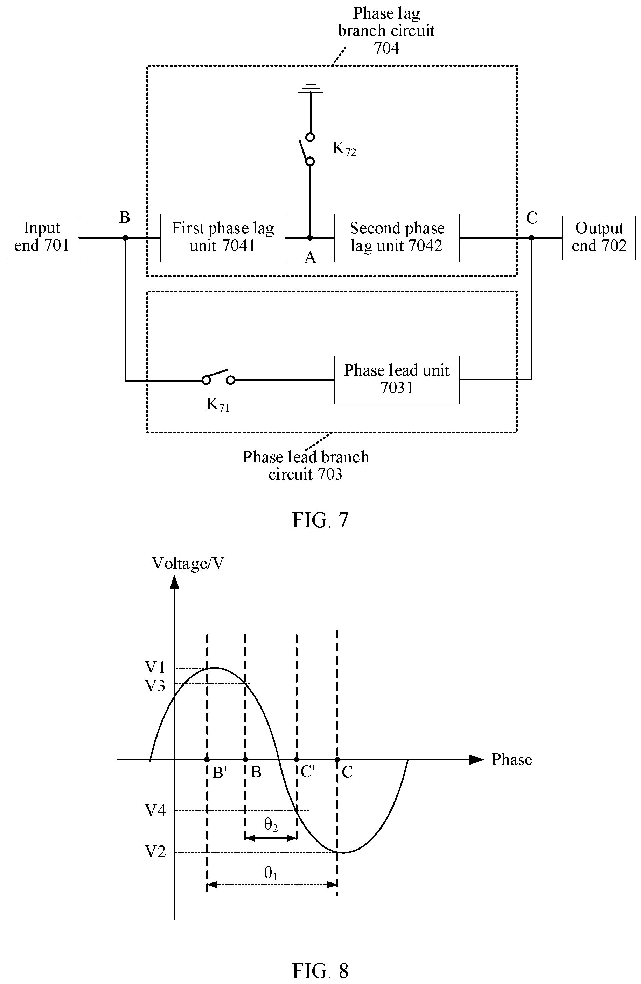

First, FIG. 7 is a circuit block diagram of a phase shift circuit according to an embodiment of this application. As shown in FIG. 7, the phase shift circuit includes an input end 701, an output end 702, a phase lead branch circuit 703, and a phase lag branch circuit 704. The phase lead branch circuit 703 and the phase lag branch circuit 704 are connected in parallel between the input end 701 and the output end 702.

The phase lead branch circuit 703 includes a first radio frequency switch unit and a phase lead unit 7031, and the phase lag branch circuit 704 includes a first phase lag unit 7041, a second phase lag unit 7042, and a second radio frequency switch unit.

It should be explained that, in this embodiment of this application, an example in which the first radio frequency switch unit and the second radio frequency switch unit each are specifically implemented as one switch is used to describe the technical solutions. In some feasible implementations, the first radio frequency switch unit and the second radio frequency switch unit may be in a specific implementation form in which two or more switches are connected in series or in parallel. In other words, a quantity of switches included in the first radio frequency switch unit and the second radio frequency switch unit is not limited in this embodiment of this application, and a serial/parallel connection between a plurality of switches included in a same radio frequency switch unit is not limited either.

Optionally, the switch may be implemented as a mechanical switch or a semiconductor switch. The semiconductor switch may include, for example, a ferrite switch, a GaN switch, an SOI switch, and a PIN switch. In other words, types of switches included in the first radio frequency switch unit and the second radio frequency switch unit are not limited in this embodiment of this application.

It may be understood that, when the first radio frequency switch unit and the second radio frequency switch unit are specifically implemented as semiconductor switches, the first radio frequency switch unit and the second radio frequency switch unit may be integrated into one switch chip, or the first radio frequency switch unit and the second radio frequency switch unit may be two switch chips separately. Product forms of the first radio frequency switch unit and the second radio frequency switch unit are not limited in this embodiment of this application.

In this case, a connection relationship in the phase shift circuit may be as follows: A switch *K*₇₁ and the phase lead unit 7031 are connected in series between the input end 701 and the output end 702. The first phase lag unit 7041 and the second phase lag unit 7042 are connected in series between the input end 701 and the output end 702. A first connection point A between the first phase lag unit 7041 and the second phase lag unit 7042 is connected to a first end of a switch *K*₇₂, and a second end of the switch *K*₇₂ is grounded.

It may be understood that a relative position relationship between the switch *K*₇₁ and the phase lead unit 7031 shown in FIG. 7 is an example. In some feasible implementations, positions of the first radio frequency switch unit and the phase lead unit may be exchanged. In other words, the first radio frequency switch unit is connected to the output end, and the phase lead unit is connected to the input end. In this case, the first radio frequency switch unit and the phase lead unit are still connected in series between the input end and the output end.

Similarly, a relative position relationship between the first phase lag unit 7041 and the second phase lag unit 7042 shown in FIG. 7 is an example. In some feasible implementations, positions of the first phase lag unit and the second phase lag unit may be exchanged. In other words, the first phase lag unit is connected to the output end, and the second phase lag unit is connected to the input end. In this case, the first phase lag unit and the second phase lag unit are still connected in series between the input end and the output end.

In this embodiment of this application, the first radio frequency switch unit and the second radio frequency switch unit are simultaneously on or off. In other words, the switch *K*₇₁ and the switch *K*₇₂ are simultaneously on or off. For example, on or off of the radio frequency switch unit may be controlled by a controller.

When the switch *K*₇₁ and the switch *K*₇₂ are in an on state, a radio frequency signal input by the input end 701 may be transmitted to the output end 702 through the switch *K*₇₁ and the phase lead unit 7031 in the phase lead branch circuit 703. In this case, a phase of a radio frequency signal output by the output end 702 leads the phase of the radio frequency signal input by the input end 701.

In some feasible implementations, the radio frequency signal input by the input end 701 may be transmitted to the output end 702 through the switch *K*₇₁ and the phase lead unit 7031 in the phase lead branch circuit 703, and may be further transmitted to the output end 702 through the first phase lag unit 7041 and the second phase lag unit 7042 in the phase lag branch circuit 704. In this case, a most part of the radio frequency signal input by the input end 701 is transmitted to the output end 702 through the phase lead branch circuit 703, and a small part of the radio frequency signal is transmitted to the output end 702 through the phase lag branch circuit 704. For example, the input end 701 inputs a seventh radio frequency signal. When the seventh radio frequency signal is transmitted to a point B, 90% of the seventh radio frequency signal is transmitted to a point C through the switch *K*₇₁ and the phase lead unit 7031, to obtain an eighth radio frequency signal, and 10% of the seventh radio frequency signal is transmitted to the point C through the first phase lag unit 7041 and the second phase lag unit 7042, to obtain a ninth radio frequency signal. The eighth radio frequency signal and the ninth radio frequency signal are combined at the point C, to obtain a tenth radio frequency signal, and the tenth radio frequency signal is output by the output end 702. Although the seventh radio frequency signal passes through the phase lag branch circuit 704, because a most part of the seventh radio frequency signal passes through the phase lead branch circuit 703, a phase of the tenth radio frequency signal obtained through combination still leads that of the seventh radio frequency signal. In other words, when the switch *K*₇₁ and the switch *K*₇₂ are in an on state, the phase of the radio frequency signal output by the output end 702 leads the phase of the radio frequency signal input by the input end 701.

When the switch *K*₇₁ and the switch *K*₇₂ are in an off state, the radio frequency signal input by the input end 701 is transmitted to the output end 702 through the first phase lag unit 7041 and the second phase lag unit 7042 in the phase lag branch circuit 704. In this case, although the switch *K*₇₁ is in an off state, and the phase lead branch circuit 703 is disconnected, during transmission of the radio frequency signal, the switch *K*₇₁ and the phase lead unit 7031 in the phase lead branch circuit 703 may be coupled to the point B and the point C through an inductor and a capacitor, respectively. However, in general, when the switch *K*₇₁ and the switch *K*₇₂ are in an off state, the phase lead branch circuit 703 is specifically equivalent to a capacitive branch circuit, and the capacitive branch circuit is connected in parallel to the ground and loaded at the point B and the point C, to further increase a phase lag amount of the phase lag branch circuit 704. In this case, the radio frequency signal input by the input end 701 is transmitted to the output end 702 through the first phase lag unit 7041 and the second phase lag unit 7042, and the phase of the radio frequency signal output by the output end 702 lags behind the phase of the radio frequency signal input by the input end 701.

For example, when the switch *K*₇₁ and the switch *K*₇₂ are in an on state, the phase of the radio frequency signal output by the output end 702 leads the phase of the radio frequency signal input by the input end 701 by 45°, which is represented as +45°. When the switch *K*₇₁ and the switch *K*₇₂ are in an off state, the phase of the radio frequency signal output by the output end 702 lags behind the phase of the radio frequency signal input by the input end 701 by 45°, which is represented as -45°. In this case, a phase shift amount that may be implemented by the phase shift circuit is +45° - (-45°) = 90°.

It is assumed that the phase shift circuit shown in FIG. 1 in the conventional technology is used to implement a phase shift amount of 90°. If a phase of a radio frequency signal passing through a transmission line L1 lags by 0°, a phase of the radio frequency signal passing through a transmission line L2 needs to lag by 90°. In this way, the phase shift circuit can implement the phase shift amount of 90°. In this embodiment of this application, the phase lag branch circuit 704 only needs to have a phase lag of 45° to implement 90° phase shift. To be specific, in this embodiment of this application, the phase lead unit is used to obtain a phase lead when the switch *K*₇₁ and the switch *K*₇₂ are in an on state, to reduce phase lag amounts of the switch *K*₇₁ and the switch *K*₇₂ in an off state. Because a value of the phase lag amount is positively correlated with a length of a transmission line in the phase lag branch circuit, in this embodiment of this application, the phase lead unit is added, so that when the phase shift amount that is the same as that of an existing phase shift circuit is obtained, a phase lag amount that needs to be implemented by the phase lag unit may be reduced, to reduce a length of a transmission line in the phase lag unit, further reduce a volume occupied by the phase shift circuit, and facilitate miniaturization of the phase shift circuit. In addition, the volume occupied by the phase shift circuit is reduced, and a volume of a PCB on which the phase shift circuit is etched may also be reduced, to reduce material costs.

Further, because the phase lead unit is used in this embodiment of this application, voltages that need to be borne by two ends of the first radio frequency switch unit and the second radio frequency switch unit are reduced, to improve security of the phase shift circuit. Specifically, FIG. 8 is a diagram of a radio frequency signal according to an embodiment of this application. As shown in FIG. 8, it is assumed that the phase shift circuit does not use the phase lead unit 7031. The first radio frequency switch unit, the second radio frequency switch unit, the first phase lag unit, and the second phase lag unit are shown in FIG. 7. If the phase shift circuit that does not use the phase lead unit 7031 needs to implement a same phase shift amount as the phase shift circuit that uses the phase lead unit 7031, when the switch *K*₇₁ and the switch *K*₇₂ are in an off state, the phase shift circuit that does not use the phase lead unit 7031 needs to have a phase lag *θ*₁, that is, a phase difference between a point B' and a point C' shown in FIG. 8. In this case, a voltage difference between the input end 701 and the output end 702 is V1-V2, in other words, a voltage that needs to be borne by two ends of the switch *K*₇₁ is V1-V2. In this embodiment of this application, the phase shift circuit that uses the phase lead unit 7031 only needs to have a phase lag *θ*₂, that is, a phase difference between a point B and a point C shown in FIG. 8, and *θ*₂ is less than *θ*₁. In this case, a voltage difference between the input end 701 and the output end 702 is V3-V4, in other words, a voltage that needs to be borne by the two ends of the switch *K*₇₁ is V3-V4. It may be learned that V3-V4 is less than V1-V2. Therefore, in this embodiment of this application, a voltage loaded between the input end and the output end can be reduced by using the phase lead unit, to reduce a voltage that needs to be borne by two ends of the first radio frequency switch unit.

It may be understood that a voltage that needs to be borne by two ends of the switch *K*₇₂ is a voltage divided between the input end 701 and the output end 702 at a point A. In this embodiment of this application, the phase lead unit is used to reduce a voltage loaded between the input end 701 and the output end 702, and the voltage that needs to be borne by the two ends of the switch *K*₇₂ is naturally reduced.

The switch *K*₇₁ needs to bear most of the voltage between the input end 701 and the output end 702, and the switch *K*₇₂ bears the voltage divided between the input end 701 and the output end 702 at the point A. In other words, the voltage that needs to be borne by the two ends of the switch *K*₇₁ is greater than the voltage that needs to be borne by the two ends of the switch *K*₇₂. Therefore, the switch *K*₇₁ is a decisive factor that restricts a power capacity of the phase shift circuit. For example, if power of the phase shift circuit needs to be increased, an amplitude of the radio frequency signal input by the input end 701 increases, an amplitude of the radio frequency signal output by the output end 702 also increases, and the voltage that needs to be borne by the two ends of the switch *K*₇₁ increases. In this embodiment of this application, the phase lead unit 7031 is used to reduce the voltage that needs to be borne by the two ends of the switch *K*₇₁. Assuming that no phase lead unit 7031 is used, the power capacity of the phase shift circuit can only be 100 W. Correspondingly, the voltage that needs to be borne by the two ends of the switch *K*₇₁ reaches 50 V. However, according to this embodiment of this application, when the power capacity of the phase shift circuit is 100 W, correspondingly, the voltage that needs to be borne by the two ends of the switch *K*₇₁ is only 25 V. It may be understood that, in this case, the voltage that needs to be borne by the two ends of the switch *K*₇₁ decreases, and a linear indicator of the phase shift circuit becomes better. For example, a third-order intercept point IIP3 (Third-order Intercept Point) may be clearly improved. Assuming that the switch *K*₇₁ is a switch that may withstand a voltage of 50 V, the power capacity of the phase shift circuit provided in this embodiment of this application may reach 400 W.

Under a same power capacity requirement, according to this embodiment of this application, a switch that can withstand a smaller voltage may be used, and a linear indicator is improved. Alternatively, according to this embodiment of this application, the power capacity of the phase shift circuit may be increased by using a switch that can withstand a same voltage.

In comparison with the existing phase shift circuit that uses a switch that can withstand a higher voltage or uses a plurality of switches connected in series to increase the power capacity, causing higher costs, in this embodiment of this application, the voltage loaded between the input end and the output end is reduced, so that the power capacity of the phase shift circuit may be increased, to reduce costs.

Therefore, this embodiment of this application can be better applied to an application scenario with a high power capacity and a high linear indicator requirement, and achieves low costs.

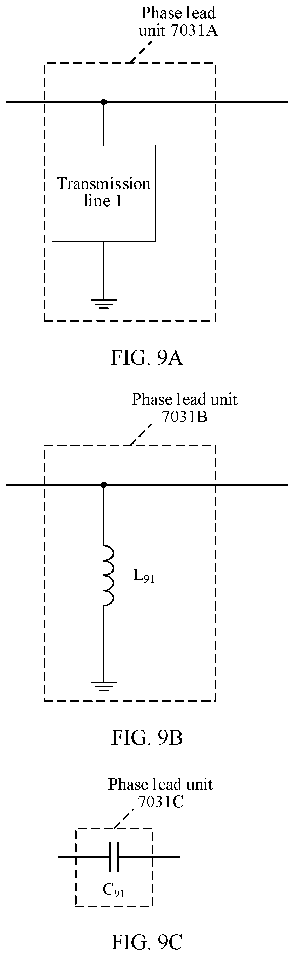

The following describes an example of various possible circuit structures of the phase lead unit 7031 with reference to FIG. 9A to FIG. 9H.

In some feasible implementations, the phase lead unit 7031 may include a first inductive unit. In this case, the phase lead unit 7031 may be specifically implemented as a phase lead unit 7031A shown in FIG. 9A or a phase lead unit 7031B shown in FIG. 9B.

For example, as shown in FIG. 9A, the phase lead unit 7031A may be considered as a two-port network, and is connected to the switch *K*₇₁ in series between the input end 701 and the output end 702.

The phase lead unit 7031A includes a transmission line 1. In other words, the first inductive unit is specifically implemented as the transmission line 1.

It should be noted that the transmission line in this application is an apparatus for guiding transmission of an electromagnetic wave, and includes but is not limited to a microstrip or a strip line printed on a printed circuit board (Printed Circuit Board, PCB).

The transmission line 1 is disposed between the input end 701 and the switch *K*₇₁. To be specific, a first end of the transmission line 1 is connected to the input end 701 and the switch *K*₇₁, and a second end of the transmission line 1 is grounded. Alternatively, the transmission line 1 is disposed between the switch *K*₇₁ and the output end 702. To be specific, a first end of the transmission line 1 is connected to the switch *K*₇₁ and the output end 702, and a second end of the transmission line 1 is grounded.

In this case, a length of the transmission line 1 is less than 1/4 of a wavelength of the radio frequency signal input by the input end 701, and the transmission line 1 is presented as inductive.

In this embodiment of this application, through an inductive transmission line to ground, the phase of the radio frequency signal output by the output end leads the phase of the radio frequency signal input by the input end.

For another example, as shown in FIG. 9B, the phase lead unit 7031B includes an inductor *L*₉₁. In other words, the first inductive unit is specifically implemented as the inductor *L*₉₁.

Similarly, the phase lead unit 7031B may also be considered as a two-port network, and is connected to the switch *K*₇₁ in series between the input end 701 and the output end 702.

The inductor *L*₉₁ is disposed between the input end 701 and the switch *K*₇₁. To be specific, a first end of the inductor *L*₉₁ is connected to the input end 701 and the switch *K*₇₁, and a second end of the inductor *L*₉₁ is grounded. Alternatively, the inductor *L*₉₁ is disposed between the switch *K*₇₁ and the output end 702. To be specific, a first end of the inductor *L*₉₁ is connected to the switch *K*₇₁ and the output end 702, and a second end of the inductor *L*₉₁ is grounded.

In this embodiment of this application, through an inductor to ground, the phase of the radio frequency signal output by the output end leads the phase of the radio frequency signal input by the input end.

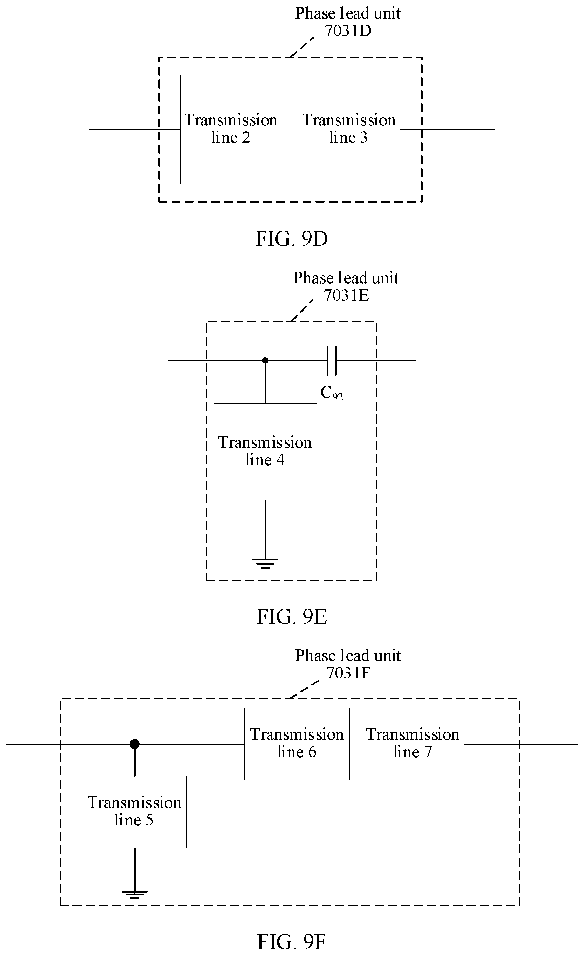

Optionally, in some feasible implementations, the phase lead unit 7031 may include a first capacitive unit. In this case, the phase lead unit 7031 may be specifically implemented as a phase lead unit 7031C shown in FIG. 9C or a phase lead unit 7031D shown in FIG. 9D.

For example, as shown in FIG. 9C, the phase lead unit 7031C includes a capacitor *C*₉₁. In other words, the first capacitive unit is specifically implemented as the capacitor *C*₉₁. The capacitor *C*₉₁ is disposed between the switch *K*₇₁ and the output end 702. To be specific, a first end of the capacitor *C*₉₁ is connected to the switch *K*₇₁, and a second end of the capacitor *C*₉₁ is connected to the output end 702. Alternatively, the capacitor *C*₉₁ is disposed between the input end 701 and the switch *K*₇₁. To be specific, a first end of the capacitor *C*₉₁ is connected to the input end 701, and a second end of the capacitor *C*₉₁ is connected to the switch *K*₇₁.

In this embodiment of this application, the capacitor is connected in series between the input end and the output end, so that the phase of the radio frequency signal output by the output end leads the phase of the radio frequency signal input by the input end.

For another example, as shown in FIG. 9D, the phase lead unit 7031D includes a transmission line 2 and a transmission line 3. The transmission line 2 and the transmission line 3 are coupled in parallel, and are presented as capacitive. In other words, the first capacitive unit is specifically implemented as two transmission lines coupled in parallel.

In this case, the two transmission lines coupled in parallel are disposed between the switch *K*₇₁ and the output end 702. To be specific, the transmission line 2 is connected to the switch *K*₇₁, and the transmission line 3 is connected to the output end 702. Alternatively, the two transmission lines coupled in parallel are disposed between the input end 701 and the switch *K*₇₁. To be specific, the transmission line 2 is connected to the input end 701, and the transmission line 3 is connected to the switch *K*₇₁. Lengths of the transmission line 2 and the transmission line 3 are related to a phase that the phase lead branch circuit needs to lead.

In this embodiment of this application, the two transmission lines coupled in parallel are connected in series between the input end and the output end, so that the phase of the radio frequency signal output by the output end leads the phase of the radio frequency signal input by the input end.

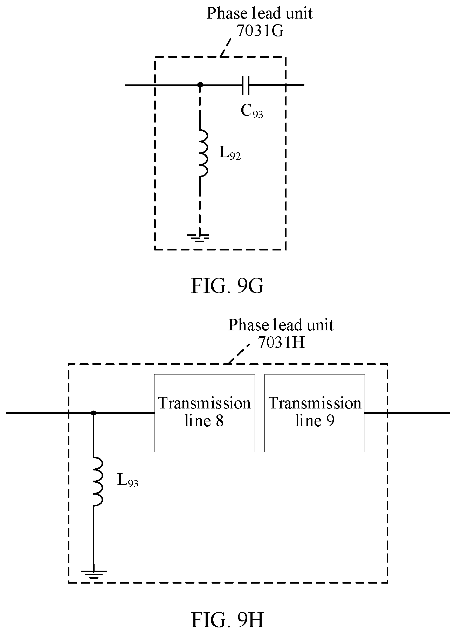

Further, in some feasible implementations, the phase lead unit 7031 may further include a second inductive unit in addition to the first capacitive unit. A first end of the second inductive unit is connected to a second connection point, the second connection point is a connection point between the first radio frequency switch unit and the first capacitive unit, and a second end of the second inductive unit is grounded. In this case, the phase lead unit 7031 may be specifically implemented as a phase lead unit 7031E shown in FIG. 9E, a phase lead unit 7031F shown in FIG. 9F, a phase lead unit 7031G shown in FIG. 9G, or a phase lead unit 7031H shown in FIG. 9H.

For example, as shown in FIG. 9E, the phase lead unit 7031E includes a capacitor *C*₉₂ and a transmission line 4. The phase lead unit 7031E is disposed between the switch *K*₇₁ and the output end 702. A first end of the capacitor *C*₉₂ is connected to the switch *K*₇₁ and a first end of the transmission line 4, a second end of the capacitor *C*₉₂ is connected to the output end 702, and a second end of the transmission line 4 is grounded. Alternatively, the phase lead unit 7031E is disposed between the input end 701 and the switch *K*₇₁. In this case, a first end of the capacitor *C*₉₂ is connected to the switch *K*₇₁ and a first end of the transmission line 4, a second end of the capacitor *C*₉₂ is connected to the input end 701, and a second end of the transmission line 4 is grounded.

It may be learned that the phase lead unit 7031E is a combination of the phase lead unit 7031A shown in FIG. 9A and the phase lead unit 7031C shown in FIG. 9C. To be specific, in this embodiment of this application, a transmission line is connected to the ground and a capacitor is connected in series between the input end and output end, so that the phase of the radio frequency signal output by the output end leads the phase of the radio frequency signal input by the input end. According to this embodiment of this application, a phase lead amount of the phase lead unit may be further increased.

For another example, as shown in FIG. 9F, the phase lead unit 7031F includes a transmission line 5, a transmission line 6, and a transmission line 7. The transmission line 6 and the transmission line 7 are coupled in parallel, and are presented as capacitive. The length of the transmission line 1 is less than 1/4 of the wavelength of the radio frequency signal input by the input end 701, and the transmission line 1 is presented as inductive.

In this case, the phase lead unit 7031F is disposed between switch *K*₇₁ and the output end 702. The transmission line 6 is connected to the switch *K*₇₁ and a first end of the transmission line 5, the transmission line 7 is connected to the output end 702, and a second end of the transmission line 5 is grounded. Alternatively, the phase lead unit 7031F is disposed between the input end 701 and the switch *K*₇₁. The transmission line 7 is connected to the input end 701, the transmission line 6 is connected to the switch *K*₇₁ and a first end of the transmission line 5, and a second end of the transmission line 5 is grounded.

It may be learned that the phase lead unit 7031F is a combination of the phase lead unit 7031A shown in FIG. 9A and the phase lead unit 7031D shown in FIG. 9D. To be specific, in this embodiment of this application, a transmission line is connected to the ground and two transmission lines coupled in parallel are connected in series between the input end and output end, so that the phase of the radio frequency signal output by the output end leads the phase of the radio frequency signal input by the input end. According to this embodiment of this application, the phase lead amount of the phase lead unit may be further increased.

For another example, as shown in FIG. 9G, the phase lead unit 7031G includes a capacitor *C*₉₃ and an inductor *L*₉₂.

The phase lead unit 7031G is disposed between the switch *K*₇₁ and the output end 702. A first end of the capacitor *C*₉₃ is connected to the switch *K*₇₁ and a first end of the inductor *L*₉₂, a second end of the capacitor *C*₉₃ is connected to the output end 702, and a second end of the inductor *L*₉₂ is grounded. Alternatively, the phase lead unit 7031G is disposed between the input end 701 and the switch *K*₇₁. A first end of the capacitor *C*₉₃ is connected to the switch *K*₇₁ and a first end of the inductor *L*₉₂, a second end of the capacitor *C*₉₃ is connected to the input end 701, and a second end of the inductor *L*₉₂ is grounded.

It may be learned that the phase lead unit 7031G is a combination of the phase lead unit 7031B shown in FIG. 9B and the phase lead unit 7031C shown in FIG. 9C. To be specific, in this embodiment of this application, an inductor is connected to the ground and a capacitor is connected in series between the input end and output end, so that the phase of the radio frequency signal output by the output end leads the phase of the radio frequency signal input by the input end. According to this embodiment of this application, the phase lead amount of the phase lead unit may be further increased.

For another example, as shown in FIG. 9H, the phase lead unit 7031H includes a transmission line 8, a transmission line 9, and an inductor *L*₉₃. The transmission line 8 and the transmission line 9 are coupled in parallel, and are presented as capacitive.

In this case, the phase lead unit 7031H is disposed between the switch *K*₇₁ and the output end 702. The transmission line 8 is connected to the switch *K*₇₁ and a first end of the inductor *L*₉₃, the transmission line 9 is connected to the output end 702, and a second end of the inductor *L*₉₃ is grounded. Alternatively, the phase lead unit 7031H is disposed between the input end 701 and the switch *K*₇₁. The transmission line 9 is connected to the input end 701, the transmission line 8 is connected to the switch *K*₇₁ and a first end of the inductor *L*₉₃, and a second end of the inductor *L*₉₃ is grounded.

It may be learned that the phase lead unit 7031H is a combination of the phase lead unit 7031B shown in FIG. 9B and the phase lead unit 7031D shown in FIG. 9D. To be specific, in this embodiment of this application, an inductor is connected to the ground and two transmission lines coupled in parallel are connected in series between the input end and output end, so that the phase of the radio frequency signal output by the output end leads the phase of the radio frequency signal input by the input end. According to this embodiment of this application, the phase lead amount of the phase lead unit may be further increased.

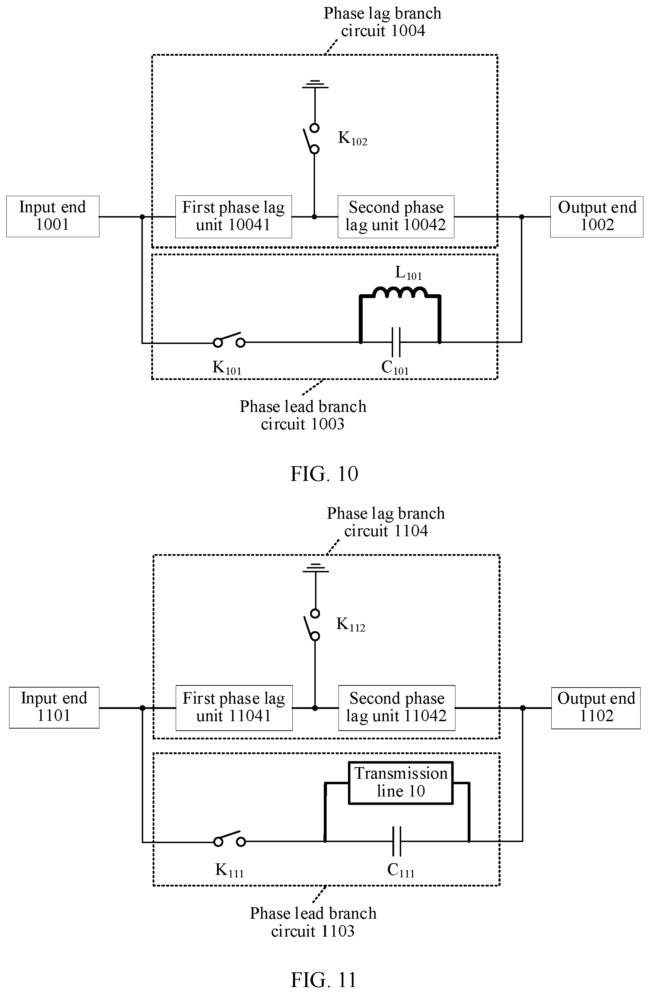

In some feasible implementations, FIG. 10 is a block diagram of another circuit structure of a phase shift circuit according to an embodiment of this application. As shown in FIG. 10, the phase shift circuit includes an input end 1001, an output end 1002, a phase lead branch circuit 1003, and a phase lag branch circuit 1004. The phase lead branch circuit 1003 and the phase lag branch circuit 1004 are connected in parallel between the input end 1001 and the output end 1002.

The phase lead branch circuit 1003 includes a first radio frequency switch unit, a phase lead unit, and a third inductive unit. The phase lead unit includes the first capacitive unit.

In this embodiment of this application, an example in which the first radio frequency switch unit includes a switch *K*₁₀₁, the first capacitive unit includes a capacitor *C*₁₀₁, and the third inductive unit includes an inductor *L*₁₀₁ is used. The switch *K*₁₀₁ and the capacitor *C*₁₀₁ are connected in series between the input end 1001 and the output end 1002, and the inductor *L*₁₀₁ and the capacitor *C*₁₀₁ are connected in parallel.

Optionally, the first capacitive unit may include two transmission lines coupled in parallel. In some feasible implementations, the inductor *L*₁₀₁ may be connected in parallel to two ends of the two transmission lines coupled in parallel.

The phase lag branch circuit 1004 includes a first phase lag unit 10041, a second phase lag unit 10042, and a second radio frequency switch unit. The first phase lag unit 10041 and the second phase lag unit 10042 are connected in series between the input end 1001 and the output end 1002. An example in which the second radio frequency switch unit includes a switch *K*₁₀₂ is used. A first connection point between the first phase lag unit 10041 and the second phase lag unit 10042 is connected to a first end of the switch *K*₁₀₂, and a second end of the switch *K*₁₀₂ is grounded.

In this embodiment of this application, the first capacitive unit and the third inductive unit form a first LC resonant network. In other words, the capacitor *C*₁₀₁ and the inductor *L*₁₀₁ form the first LC resonant network. In this case, the first LC resonant network is presented as capacitive in a primary operating frequency band, for example, 3.5 GHz, and is presented as being in a high-impedance state in another frequency band outside the primary operating frequency band. The phase lead branch circuit 1003 may still implement that a phase of a radio frequency signal output by the output end 1002 leads a phase of a radio frequency signal input by the input end 1001.

A capacitance value of the capacitor *C*₁₀₁ and an inductance value of the inductor *L*₁₀₁ are related to a size of the primary operating frequency band.

A difference from the phase shift circuit shown in FIG. 7 lies in that, in this embodiment of this application, an inductor connected in parallel to the first capacitive unit is added to two ends of the first capacitive unit. Therefore, in addition to effects of the phase shift circuit shown in FIG. 7, such as a small volume of the phase shift circuit, low costs, a low voltage that needs to be borne by two ends of a radio frequency switch unit, a large power capacity of the phase shift circuit, and a good linear indicator, in this embodiment of this application, the phase shift circuit provided in this embodiment of this application may further suppress a signal on the another frequency band outside the primary operating frequency band. For example, in a multi-frequency system and an architecture in which an active module and a passive module are integrated, a frequency division duplex (Frequency Division Duplex, FDD) frequency band signal is leaked to a phase shift circuit through coupling. A frequency of the FDD frequency band signal is, for example, 1.8 GHz, a frequency of a primary operating frequency band signal is, for example, 3.5 GHz, and an FDD frequency band is a low frequency signal relative to the primary operating frequency band. When the FDD frequency band signal is leaked to the phase shift circuit, if the phase shift circuit does not suppress the FDD frequency band signal, a radio frequency switch unit in the phase shift circuit generates a cross-modulation signal, and the cross-modulation signal further affects sensitivity of receiving the FDD frequency band signal. Therefore, in this embodiment of this application, an inductor is added, and the inductor and a capacitive unit in the phase lead unit form LC resonance. Therefore, a low frequency signal outside the primary operating frequency band can be suppressed, low frequency non-linear products generated by the phase shift circuit are reduced, and impact of the phase shift circuit on another communication device is avoided.

It is assumed that no inductor connected in parallel to the first capacitive unit is added. In the multi-frequency system and the architecture in which the active module and the passive module are integrated, a dedicated filter circuit generally needs to be added at the output end of the phase shift circuit to suppress the low frequency signal outside the primary operating frequency band. As a result, an area occupied by the phase shift circuit is increased, and an insertion loss of the phase shift circuit is large. Therefore, according to this embodiment of this application, the area occupied by the phase shift circuit can be reduced, and the insertion loss can be reduced.

Optionally, in some feasible implementations, FIG. 11 is a block diagram of another circuit structure of a phase shift circuit according to an embodiment of this application. As shown in FIG. 11, the phase shift circuit includes an input end 1101, an output end 1102, a phase lead branch circuit 1103, and a phase lag branch circuit 1104. The phase lead branch circuit 1103 and the phase lag branch circuit 1104 are connected in parallel between the input end 1101 and the output end 1102.

The phase lead branch circuit 1103 includes a first radio frequency switch unit, a phase lead unit, and a third inductive unit. The phase lead unit includes the first capacitive unit.

In this embodiment of this application, an example in which the first radio frequency switch unit includes a switch *K*₁₁₁, the first capacitive unit includes a capacitor *C*₁₁₁, and the third inductive unit includes a transmission line 10 is used. The switch *K*₁₁₁ and the capacitor *C*₁₁₁ are connected in series between the input end 1101 and the output end 1102, and the transmission line 10 and the capacitor *C*₁₁₁ are connected in parallel.

Similarly, the first capacitive unit may include two transmission lines coupled in parallel. In some feasible implementations, the transmission line 10 may be connected in parallel to two ends of the two transmission lines coupled in parallel.

The phase lag branch circuit 1104 includes a first phase lag unit 11041, a second phase lag unit 11042, and a second radio frequency switch unit. The first phase lag unit 11041 and the second phase lag unit 11042 are connected in series between the input end 1101 and the output end 1102. An example in which the second radio frequency switch unit includes a switch *K*₁₁₂ is used. A first connection point between the first phase lag unit 11041 and the second phase lag unit 11042 is connected to a first end of the switch *K*₁₁₂, and a second end of the switch *K*₁₁₂ is grounded.

A difference from the phase shift circuit shown in FIG. 10 lies in that, the third inductive unit in the phase shift circuit provided in this embodiment of this application is specifically implemented as a transmission line, so that an effect of the phase shift circuit provided in FIG. 10 can be achieved, and use of an inductor component can be reduced, to further reduce costs.

It should be explained that FIG. 10 and FIG. 11 provide example descriptions in which the phase lead unit is specifically implemented as a capacitor and an inductor or a transmission line is connected in parallel at two ends of the capacitor. In some feasible implementations, the phase lead unit may be specifically implemented as the phase lead unit shown in FIG. 9D to FIG. 9H. To be specific, an inductor or a transmission line is connected in parallel at two ends of two transmission lines coupled in parallel, or an inductor or a transmission line is added at the second connection point between the first radio frequency switch unit and the first capacitive unit.

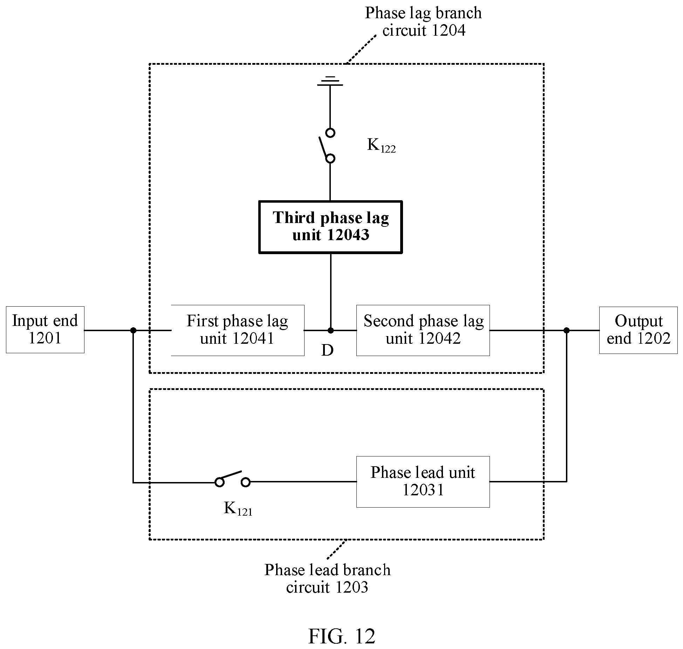

Optionally, in some feasible implementations, FIG. 12 is a block diagram of another circuit structure of a phase shift circuit according to an embodiment of this application. As shown in FIG. 12, the phase shift circuit includes an input end 1201, an output end 1202, a phase lead branch circuit 1203, and a phase lag branch circuit 1204. The phase lead branch circuit 1203 and the phase lag branch circuit 1204 are connected in parallel between the input end 1201 and the output end 1202.

The phase lead branch circuit 1203 includes a first radio frequency switch unit and a phase lead unit 12031. In this embodiment of this application, an example in which the first radio frequency switch unit is specifically implemented as a switch *K*₁₂₁ is used. The switch *K*₁₂₁ and the phase lead unit 12031 are connected in series between the input end 1201 and the output end 1202.

The phase lag branch circuit 1204 includes a first phase lag unit 12041, a second phase lag unit 12042, a third phase lag unit 12043, and a second radio frequency switch unit. In this embodiment of this application, an example in which the second radio frequency switch unit is specifically implemented as a switch *K*₁₂₂ is used. The first phase lag unit 12041 and the second phase lag unit 12042 are connected in series between the input end 1201 and the output end 1202. In addition, the third phase lag unit 12043 and the switch *K*₁₂₂ are connected in series between the ground and a first connection point D between the first phase lag unit 12041 and the second phase lag unit 12042.

It may be understood that a relative position relationship between the third phase lag unit 12043 and the switch *K*₁₂₂ shown in FIG. 12 is an example. In some feasible implementations, positions of the third phase lag unit and the second radio frequency switch unit may be exchanged. In other words, the second radio frequency switch unit is connected to the first connection point, and the third phase lag unit is grounded. In this case, the third phase lag unit and the second radio frequency switch unit are still connected in series between the first connection point and the ground.

It may be learned that, in comparison with the phase shift circuit shown in FIG. 7, the third phase lag unit 12043 is added to the phase shift circuit provided in this embodiment of this application. In this case, in this embodiment of this application, when the switch *K*₇₁ and the switch *K*₇₂ are in an off state, the phase lag branch circuit 1204 can further increase a lagging degree of a phase of a radio frequency signal input by the input end 1201. For example, when a phase of a radio frequency signal output by the output end 702 needs to lag behind a phase of a radio frequency signal input by the input end 701 by 45°, the first phase lag unit 7041 and the second phase lag unit 7042 shown in FIG. 7 implement a phase lag of 45°. However, in this embodiment of this application, the first phase lag unit 12041, the second phase lag unit 12042, and the third phase lag unit 12043 jointly implement a phase lag of 45°. It is assumed that each phase lag unit is specifically implemented as a transmission line. According to this embodiment of this application, based on effects of the phase shift circuit shown in FIG. 7, lengths of transmission lines in the first phase lag unit and the second phase lag unit are further shortened, and a volume occupied by the phase shift circuit is reduced.

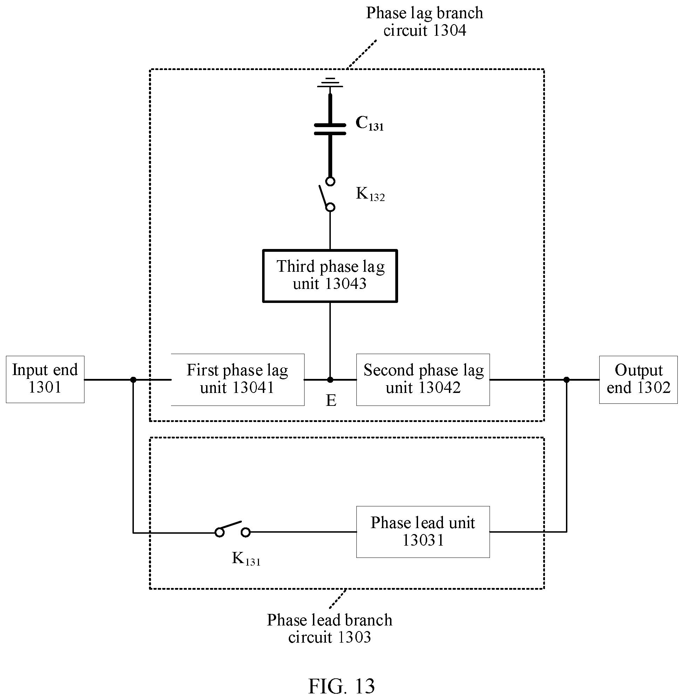

Further, in some feasible implementations, FIG. 13 is a block diagram of another circuit structure of a phase shift circuit according to an embodiment of this application. As shown in FIG. 13, the phase shift circuit includes an input end 1301, an output end 1302, a phase lead branch circuit 1303, and a phase lag branch circuit 1304. The phase lead branch circuit 1303 and the phase lag branch circuit 1304 are connected in parallel between the input end 1301 and the output end 1302.

The phase lead branch circuit 1303 includes a first radio frequency switch unit and a phase lead unit 13031. In this embodiment of this application, an example in which the first radio frequency switch unit is specifically implemented as a switch *K*₁₃₁ is used. The switch *K*₁₃₁ and the phase lead unit 13031 are connected in series between the input end 1301 and the output end 1302.

The phase lag branch circuit 1304 includes a first phase lag unit 13041, a second phase lag unit 13042, a third phase lag unit 13043, a second radio frequency switch unit, and a second capacitive unit. In this embodiment of this application, an example in which the second radio frequency switch unit is specifically implemented as a switch *K*₁₃₂, and the second capacitive unit is specifically implemented as a capacitor *C*₁₃₁ is used. The first phase lag unit 13041 and the second phase lag unit 13042 are connected in series between the input end 1301 and the output end 1302. In addition, a connection point between the first phase lag unit 13041 and the second phase lag unit 13042 is a first connection point E, and the third phase lag unit 13043, the switch *K*₁₃₂, and the capacitor *C*₁₃₁ are connected in series between the first connection point E and the ground.

It may be understood that a relative position relationship between the third phase lag unit 13043, the switch *K*₁₃₂, and the capacitor *C*₁₃₁ shown in FIG. 13 is an example. In some feasible implementations, positions of the third phase lag unit, the second radio frequency switch unit, and the second capacitive unit may be exchanged. For example, the second radio frequency switch unit is connected to the first connection point, the second capacitive unit is connected between the second radio frequency switch unit and the third phase lag unit, and the third phase lag unit is grounded; or the second capacitive unit is connected to the first connection point, the second radio frequency switch unit is connected between the second capacitive unit and the third phase lag unit, and the third phase lag unit is grounded, provided that the third phase lag unit, the second radio frequency switch unit, and the second capacitive unit are still connected in series between the first connection point and the ground.

Optionally, the second capacitive unit may further be specifically implemented as two transmission lines coupled in parallel.

It may be learned that, in comparison with the phase shift circuit shown in FIG. 12, in this embodiment of this application, the second capacitive unit, for example, the capacitor *C*₁₃₁, is added. The capacitor *C*₁₃₁ may divide a voltage between the first connection point E and the ground, to further reduce a voltage that needs to be borne by two ends of the switch *K*₁₃₂.

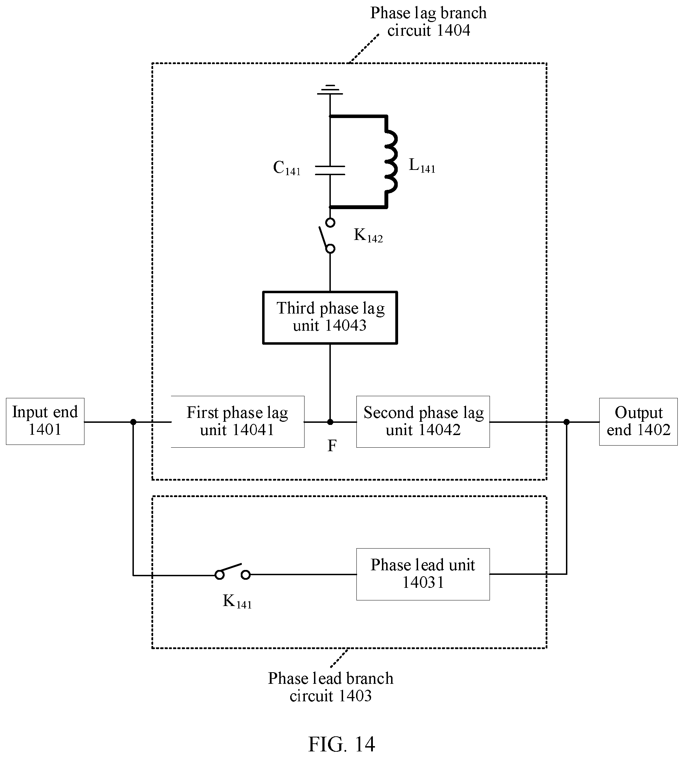

Further, in some feasible implementations, FIG. 14 is a block diagram of another circuit structure of a phase shift circuit according to an embodiment of this application. As shown in FIG. 14, the phase shift circuit includes an input end 1401, an output end 1402, a phase lead branch circuit 1403, and a phase lag branch circuit 1404. The phase lead branch circuit 1403 and the phase lag branch circuit 1404 are connected in parallel between the input end 1401 and the output end 1402.

The phase lead branch circuit 1403 includes a first radio frequency switch unit and a phase lead unit 14031. In this embodiment of this application, an example in which the first radio frequency switch unit is specifically implemented as a switch *K*₁₄₁ is used. The switch *K*₁₄₁ and the phase lead unit 14031 are connected in series between the input end 1401 and the output end 1402.

The phase lag branch circuit 1404 includes a first phase lag unit 14041, a second phase lag unit 14042, a third phase lag unit 14043, a second radio frequency switch unit, a second capacitive unit, and a fourth inductive unit. In this embodiment of this application, an example in which the second radio frequency switch unit is specifically implemented as a switch *K*₁₄₂, the second capacitive unit is specifically implemented as a capacitor *C*₁₄₁, and the fourth inductive unit is specifically implemented as an inductor *L*₁₄₁ is used. The first phase lag unit 14041 and the second phase lag unit 14042 are connected in series between the input end 1401 and the output end 1402. A connection point between the first phase lag unit 14041 and the second phase lag unit 14042 is a first connection point F. The third phase lag unit 14043, the switch *K*₁₄₂, and the capacitor *C*₁₄₁ are connected in series between the first connection point F and the ground, and the inductor *L*₁₄₁ and the capacitor *C*₁₄₁ are connected in parallel.

Optionally, the second capacitive unit may be specifically implemented as two transmission lines coupled in parallel. In some feasible implementations, the inductor may be connected in parallel to two ends of the two transmission lines coupled in parallel. Alternatively, the fourth inductive unit may be specifically implemented as a transmission line. In some feasible implementations, a transmission line whose wavelength is less than 1/4 of a wavelength of a radio frequency signal input by an input end may be connected in parallel to two ends of a capacitor, or a transmission line whose wavelength is less than 1/4 of a wavelength of a radio frequency signal input by an input end may be connected in parallel to two ends of two transmission lines coupled in parallel.

It may be learned that, in comparison with the phase shift circuit shown in FIG. 13, in this embodiment of this application, the fourth inductive unit is added. The fourth inductive unit and the second capacitive unit form a second LC resonant network. In other words, the inductor *L*₁₄₁ and the capacitor *C*₁₄₁ form the second LC resonant network. The second LC resonant network is presented as capacitive in a primary operating frequency band, for example, 3.5 GHz, and is presented as being in a high-impedance state in another frequency band outside the primary operating frequency band. In this case, the phase lag branch circuit 1404 may still implement that a phase of a radio frequency signal output by the output end 1402 lags behind a phase of a radio frequency signal input by the input end 1401.

An inductance value of the inductor *L*₁₄₁ and a capacitance value of the capacitor *C*₁₄₁ are related to a size of the primary operating frequency band.

In this embodiment of this application, an inductive unit connected in parallel to the second capacitive unit is added to two ends of the second capacitive unit. Therefore, in addition to effects of the phase shift circuit shown in FIG. 13, the phase shift circuit provided in this embodiment of this application may further suppress a signal on the another frequency band outside the primary operating frequency band, to reduce low frequency non-linear products generated by the phase shift circuit, and avoid impact of the phase shift circuit on another communication device.

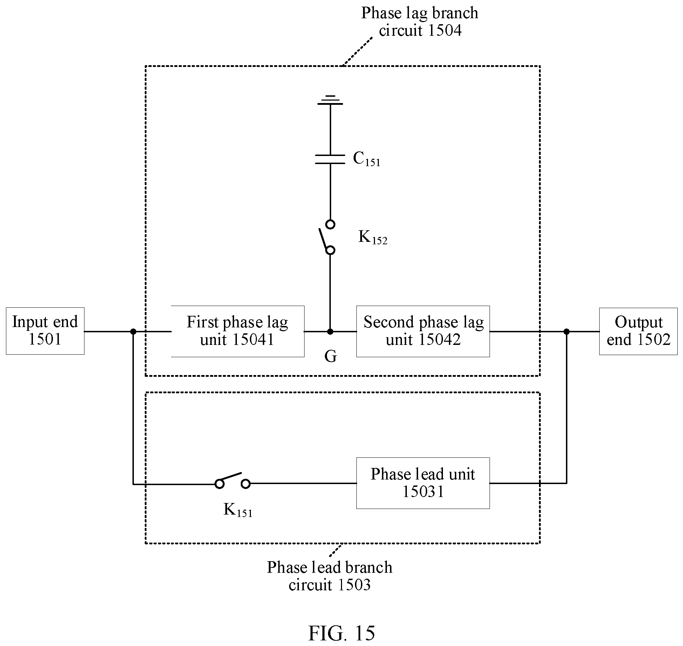

Optionally, in some feasible implementations, FIG. 15 is a block diagram of another circuit structure of a phase shift circuit according to an embodiment of this application. As shown in FIG. 15, the phase shift circuit includes an input end 1501, an output end 1502, a phase lead branch circuit 1503, and a phase lag branch circuit 1504. The phase lead branch circuit 1503 and the phase lag branch circuit 1504 are connected in parallel between the input end 1501 and the output end 1502.

The phase lead branch circuit 1503 includes a first radio frequency switch unit and a phase lead unit 15031. In this embodiment of this application, an example in which the first radio frequency switch unit is specifically implemented as a switch *K*₁₅₁ is used. The switch *K*₁₅₁ and the phase lead unit 15031 are connected in series between the input end 1501 and the output end 1502.

The phase lag branch circuit 1504 includes a first phase lag unit 15041, a second phase lag unit 15042, a second radio frequency switch unit, and a third capacitive unit. In this embodiment of this application, an example in which the second radio frequency switch unit is specifically implemented as a switch *K*₁₅₂ , and the third capacitive unit is specifically implemented as a capacitor *C*₁₅₁ is used. The first phase lag unit 15041 and the second phase lag unit 15042 are connected in series between the input end 1501 and the output end 1502. In addition, a connection point between the first phase lag unit 15041 and the second phase lag unit 15042 is a first connection point G, and the switch *K*₁₅₂ and the capacitor *C*₁₅₁ are connected in series between the first connection point G and the ground.

It may be understood that a relative position relationship between the capacitor *C*₁₅₁ and the switch *K*₁₅₂ shown in FIG. 15 is an example. In some feasible implementations, positions of the second radio frequency switch unit and the third capacitive unit may be exchanged. In other words, the third capacitive unit is connected to the first connection point, and the second radio frequency switch unit is grounded. In this case, the third capacitive unit and the second radio frequency switch unit are still connected in series between the first connection point and the ground.

Optionally, the second capacitive unit may be specifically implemented as two transmission lines coupled in parallel.

It may be learned that, in comparison with the phase shift circuit shown in FIG. 7, the third capacitive unit, for example, the capacitor *C*₁₅₁, is added to the phase shift circuit provided in this embodiment of this application. The capacitor *C*₁₅₁ may divide a voltage between the first connection point G and the ground, to reduce a voltage borne by two ends of the switch *K*₁₅₂.

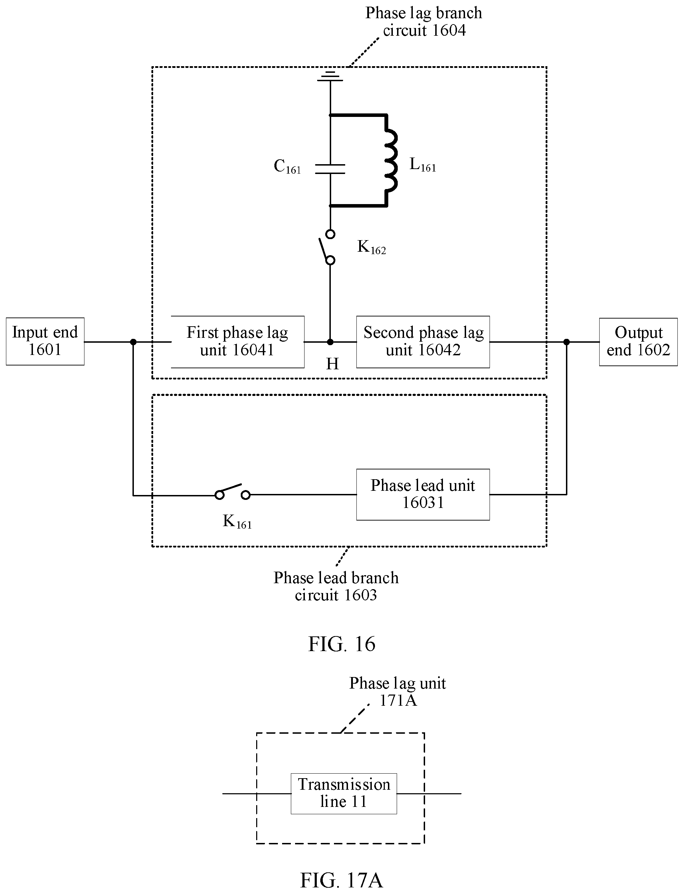

Further, in some feasible implementations, FIG. 16 is a block diagram of another circuit structure of a phase shift circuit according to an embodiment of this application. As shown in FIG. 16, the phase shift circuit includes an input end 1601, an output end 1602, a phase lead branch circuit 1603, and a phase lag branch circuit 1604. The phase lead branch circuit 1603 and the phase lag branch circuit 1604 are connected in parallel between the input end 1601 and the output end 1602.

The phase lead branch circuit 1603 includes a first radio frequency switch unit and a phase lead unit 16031. In this embodiment of this application, an example in which the first radio frequency switch unit is specifically implemented as a switch *K*₁₆₁ is used. The switch *K*₁₆₁ and the phase lead unit 16031 are connected in series between the input end 1601 and the output end 1602.

The phase lag branch circuit 1604 includes a first phase lag unit 16041, a second phase lag unit 16042, a second radio frequency switch unit, a third capacitive unit, and a fifth inductive unit. In this embodiment of this application, an example in which the second radio frequency switch unit is specifically implemented as a switch *K*₁₆₂, the third capacitive unit is specifically implemented as a capacitor *C*₁₆₁, and the fifth inductive unit is specifically implemented as an inductor *L*₁₆₁ is used. The first phase lag unit 16041 and the second phase lag unit 16042 are connected in series between the input end 1601 and the output end 1602. In addition, a connection point between the first phase lag unit 16041 and the second phase lag unit 16042 is a first connection point H, the switch *K*₁₆₂ and the capacitor *C*₁₆₁ are connected in series between the first connection point H and the ground, and the inductor *L*₁₆₁ and the capacitor *C*₁₆₁ are connected in parallel.

Optionally, the third capacitive unit may be specifically implemented as two transmission lines coupled in parallel. In some feasible implementations, the inductor may be connected in parallel to two ends of the two transmission lines coupled in parallel. Alternatively, the fifth inductive unit may be specifically implemented as a transmission line. In some feasible implementations, a transmission line whose wavelength is less than 1/4 of a wavelength of a radio frequency signal input by an input end may be connected in parallel to two ends of a capacitor, or a transmission line whose wavelength is less than 1/4 of a wavelength of a radio frequency signal input by an input end may be connected in parallel to two ends of two transmission lines coupled in parallel.

It may be learned that, in comparison with the phase shift circuit shown in FIG. 15, in this embodiment of this application, the fifth inductive unit is added. The fifth inductive unit and the third capacitive unit form a third LC resonant network. In other words, the inductor *L*₁₆₁ and the capacitor *C*₁₆₁ form the third LC resonant network. The third LC resonant network is presented as capacitive in a primary operating frequency band, for example, 3.5 GHz, and is presented as being in a high-impedance state in another frequency band outside the primary operating frequency band. In this case, the phase lag branch circuit 1604 may still implement that a phase of a radio frequency signal output by the output end 1602 lags behind a phase of a radio frequency signal input by the input end 1601.

An inductance value of the inductor *L*₁₆₁ and a capacitance value of the capacitor *C*₁₆₁ are related to a size of the primary operating frequency band.

In this embodiment of this application, an inductive unit connected in parallel to the third capacitive unit is added to two ends of the third capacitive unit. Therefore, in addition to effects of the phase shift circuit shown in FIG. 15, the phase shift circuit provided in this embodiment of this application may further suppress a signal on the another frequency band outside the primary operating frequency band, to reduce low frequency non-linear products generated by the phase shift circuit, and avoid impact of the phase shift circuit on another communication device.

The following describes an example of circuit structures of phase lag units with reference to FIG. 17A to FIG. 17K.

In some feasible implementations, the phase lag unit may include a sixth inductive unit.

For example, as shown in FIG. 17A, a phase lag unit 171A includes a transmission line 11. In other words, the sixth inductive unit is specifically implemented as a transmission line. A length of the transmission line 11 is less than 1/2 of a phase shift amount of the phase shift circuit. If the first phase lag unit and the second phase lag unit are specifically implemented as the phase lag unit 171A, a transmission line is connected in series between the input end and the output end of the phase shift circuit, so that a phase of a radio frequency signal output by the output end lags behind a phase of a radio frequency signal input by the input end.

Optionally, the third phase lag unit may be specifically implemented as the phase lag unit 171A, and the transmission line is connected in series between the ground and the first connection point between the first phase lag unit and the second phase lag unit.

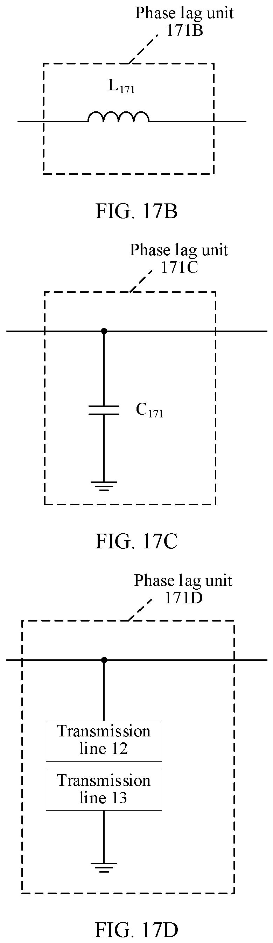

For another example, as shown in FIG. 17B, a phase lag unit 171B includes an inductor *L*₁₇₁. In other words, the sixth inductive unit may be specifically implemented as an inductor. If the first phase lag unit and the second phase lag unit are specifically implemented as the phase lag unit 171B, an inductor is connected in series between the input end and the output end of the phase shift circuit, so that a phase of a radio frequency signal output by the output end lags behind a phase of a radio frequency signal input by the input end.

Optionally, the third phase lag unit may be specifically implemented as the phase lag unit 171B, and the inductor is connected in series between the ground and the first connection point between the first phase lag unit and the second phase lag unit.

Optionally, in some feasible implementations, the phase lag unit may include a fourth capacitive unit.

For example, as shown in FIG. 17C, a phase lag unit 171C includes a capacitor *C*₁₇₁. In other words, the fourth capacitive unit is specifically implemented as a capacitor. In this case, the phase lag unit 171C may be considered as a two-port network. If the first phase lag unit and the second phase lag unit are specifically implemented as the phase lag unit 171C, a capacitor is connected in parallel to the ground between the input end and the output end of the phase shift circuit, so that a phase of a radio frequency signal output by the output end lags behind a phase of a radio frequency signal input by the input end.

Optionally, the third phase lag unit may be specifically implemented as the phase lag unit 171C, and the capacitor is connected in parallel to the ground between the ground and the first connection point between the first phase lag unit and the second phase lag unit.

For another example, as shown in FIG. 17D, a phase lag unit 171D includes a transmission line 12 and a transmission line 13. The transmission line 12 and the transmission line 13 are coupled in parallel, and are presented as capacitive. In other words, the fourth capacitive unit is specifically implemented as two transmission lines coupled in parallel. If the first phase lag unit and the second phase lag unit are specifically implemented as the phase lag unit 171D, two transmission lines coupled in parallel are connected in parallel to the ground between the input end and the output end of the phase shift circuit, so that a phase of a radio frequency signal output by the output end lags behind a phase of a radio frequency signal input by the input end.

Optionally, the third phase lag unit may be specifically implemented as the two transmission lines coupled in parallel, and the two transmission lines coupled in parallel are connected in parallel to the ground between the ground and the first connection point between the first phase lag unit and the second phase lag unit.

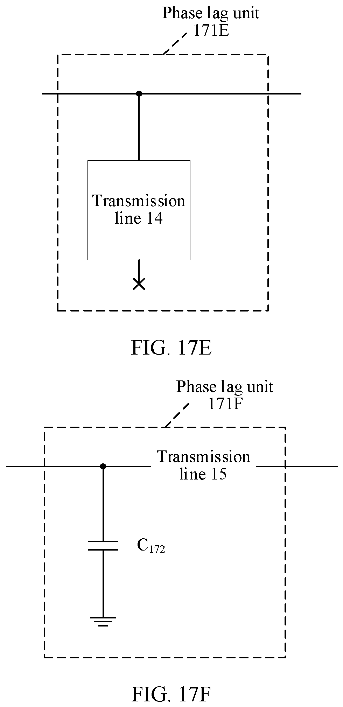

For another example, as shown in FIG. 17E, a phase lag unit 171E includes a transmission line 14. A length of the transmission line 14 is less than 1/4 of a wavelength of a radio frequency signal input by the input end, and the transmission line 14 is open to ground and is presented as capacitive. In other words, the fourth capacitive unit is specifically implemented as an open-circuited line. If the first phase lag unit and the second phase lag unit are specifically implemented as the phase lag unit 171E, an open-circuited line is connected between the input end and the output end of the phase shift circuit, so that a phase of a radio frequency signal output by the output end lags behind a phase of a radio frequency signal input by the input end.

Optionally, the third phase lag unit may be specifically implemented as the phase lag unit 171E, and the open-circuited line is connected between the ground and the first connection point between the first phase lag unit and the second phase lag unit.

Further, in some feasible implementations, the phase lag unit may include a sixth inductive unit and a fourth capacitive unit. In this case, it may be understood that the phase lag units shown in FIG. 17A and FIG. 17B and the phase lag units shown in FIG. 17C, FIG. 17D, and FIG. 17E are arranged and combined to form a new phase lag unit.

For example, as shown in FIG. 17F, a phase lag unit 171F includes a transmission line 15 and a capacitor *C*₁₇₂. The phase lag unit 171F is a combination of the phase lag unit 171A shown in FIG. 17A and the phase lag unit 171C shown in FIG. 17C.

If the first phase lag unit and the second phase lag unit are specifically implemented as the phase lag unit 171F, a transmission line is connected in series between the input end and the output end of the phase shift circuit, and a capacitor is connected in parallel to the ground between the input end and the output end, so that a phase of a radio frequency signal output by the output end lags behind a phase of a radio frequency signal input by the input end. The first phase lag unit and the second phase lag unit are symmetric with respect to the first connection point, and the first connection point is a connection point formed by connecting the first phase lag unit and the second phase lag unit in series.

Optionally, the third phase lag unit may be specifically implemented as the phase lag unit 171F, the transmission line is connected in series between the first connection point and the ground, and the capacitor is connected in parallel to the ground at a position close to the first connection point.

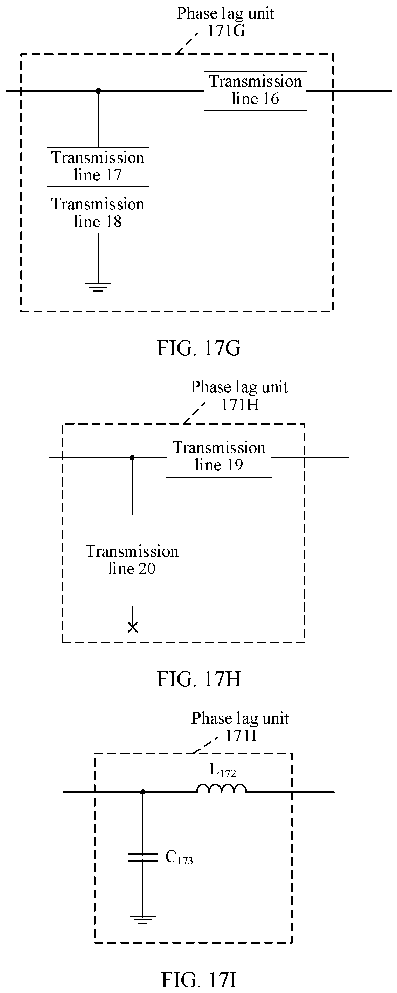

For another example, as shown in FIG. 17G, a phase lag unit 171G includes a transmission line 16, a transmission line 17, and a transmission line 18. A length of the transmission line 16 is less than 1/2 of a phase shift amount of the phase shift circuit, and the transmission line 17 and the transmission line 18 are coupled in parallel. The phase lag unit 171G is a combination of the phase lag unit 171A shown in FIG. 17A and the phase lag unit 171D shown in FIG. 17D.

If the first phase lag unit and the second phase lag unit are specifically implemented as the phase lag unit 171G, a transmission line is connected in series between the input end and the output end of the phase shift circuit, and two transmission lines coupled in parallel are connected in parallel to the ground between the input end and the output end, so that a phase of a radio frequency signal output by the output end lags behind a phase of a radio frequency signal input by the input end. The first phase lag unit and the second phase lag unit are symmetric with respect to the first connection point, and the first connection point is a connection point formed by connecting the first phase lag unit and the second phase lag unit in series.

Optionally, the third phase lag unit may be specifically implemented as the phase lag unit 171G, the transmission line is connected in series between the first connection point and the ground, and the two transmission lines coupled in parallel are connected in parallel to the ground at a position close to the first connection point.

For another example, as shown in FIG. 17H, a phase lag unit 171H includes a transmission line 19 and a transmission line 20. The phase lag unit 171H is a combination of the phase lag unit 171A shown in FIG. 17A and the phase lag unit 171E shown in FIG. 17E.

If the first phase lag unit and the second phase lag unit are specifically implemented as the phase lag unit 171H, a transmission line is connected in series between the input end and the output end of the phase shift circuit, and an open-circuited line is connected in parallel between the input end and the output end, so that a phase of a radio frequency signal output by the output end lags behind a phase of a radio frequency signal input by the input end. The first phase lag unit and the second phase lag unit are symmetric with respect to the first connection point, and the first connection point is a connection point formed by connecting the first phase lag unit and the second phase lag unit in series.

Optionally, the third phase lag unit may be specifically implemented as the phase lag unit 171H, the transmission line is connected in series between the first connection point and the ground, and the open-circuited line is connected at a position close to the first connection point.

For another example, as shown in FIG. 17I, a phase lag unit 171I includes an inductor *L*₁₇₂ and a capacitor *C*₁₇₃. The phase lag unit 171I is a combination of the phase lag unit 171B shown in FIG. 17B and the phase lag unit 171C shown in FIG. 17C.

If the first phase lag unit and the second phase lag unit are specifically implemented as the phase lag unit 171I, an inductor is connected in series between the input end and the output end of the phase shift circuit, and a capacitor is connected in parallel to the ground between the input end and the output end, so that a phase of a radio frequency signal output by the output end lags behind a phase of a radio frequency signal input by the input end. The first phase lag unit and the second phase lag unit are symmetric with respect to the first connection point, and the first connection point is a connection point formed by connecting the first phase lag unit and the second phase lag unit in series.

Optionally, the third phase lag unit may be specifically implemented as the phase lag unit 171I, the inductor is connected in series between the first connection point and the ground, and the capacitor is connected in parallel to the ground at a position close to the first connection point.

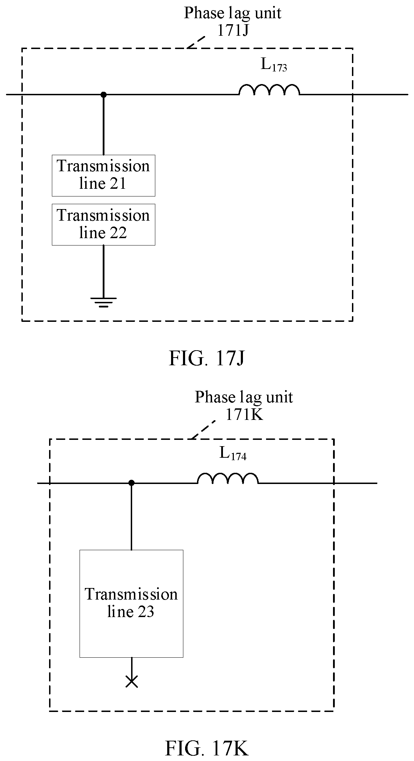

For another example, as shown in FIG. 17J, a phase lag unit 171J includes an inductor *L*₁₇₃, a transmission line 21, and a transmission line 22. The transmission line 21 and the transmission line 22 are coupled in parallel. The phase lag unit 171J is a combination of the phase lag unit 171B shown in FIG. 17B and the phase lag unit 171D shown in FIG. 17D.

If the first phase lag unit and the second phase lag unit are specifically implemented as the phase lag unit 171J, an inductor is connected in series between the input end and the output end of the phase shift circuit, and two transmission lines coupled in parallel are connected in parallel to the ground between the input end and the output end, so that a phase of a radio frequency signal output by the output end lags behind a phase of a radio frequency signal input by the input end. The first phase lag unit and the second phase lag unit are symmetric with respect to the first connection point, and the first connection point is a connection point formed by connecting the first phase lag unit and the second phase lag unit in series.

Optionally, the third phase lag unit may be specifically implemented as the phase lag unit 171J, the inductor is connected in series between the first connection point and the ground, and the two transmission lines coupled in parallel are connected in parallel to the ground at a position close to the first connection point.

For another example, as shown in FIG. 17K, a phase lag unit 171K includes an inductor *L*₁₇₄ and a transmission line 23. The phase lag unit 171K is a combination of the phase lag unit 171B shown in FIG. 17B and the phase lag unit 171E shown in FIG. 17E.

If the first phase lag unit and the second phase lag unit are specifically implemented as the phase lag unit 171K, an inductor is connected in series between the input end and the output end of the phase shift circuit, and an open-circuited line is connected in parallel to the ground between the input end and the output end, so that a phase of a radio frequency signal output by the output end lags behind a phase of a radio frequency signal input by the input end. The first phase lag unit and the second phase lag unit are symmetric with respect to the first connection point, and the first connection point is a connection point formed by connecting the first phase lag unit and the second phase lag unit in series.

Optionally, the third phase lag unit may be specifically implemented as the phase lag unit 171K, the inductor is connected in series between the first connection point and the ground, and the open-circuited line is connected in parallel to the ground at a position close to the first connection point.

It should be explained that the first phase lag unit, the second phase lag unit, and the third phase lag unit in this application each may be specifically implemented as a circuit of any one of the phase lag units shown in FIG. 17A to FIG. 17K. In a specific implementation, the phase lead units shown in FIG. 9A to FIG. 9H and the phase lag units shown in FIG. 17A to FIG. 17K may be randomly combined to obtain the phase shift circuit provided in this application.

It should be noted that the terms "first" and "second" are merely intended for a purpose of description, and shall not be understood as an indication or implication of relative importance.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A phase shift circuit, wherein the phase shift circuit comprises an input end, an output end, a phase lead branch circuit, and a phase lag branch circuit, wherein the phase lead branch circuit and the phase lag branch circuit are connected in parallel between the input end and the output end;
the phase lead branch circuit comprises a first radio frequency switch unit and a phase lead unit, and the first radio frequency switch unit and the phase lead unit are connected in series between the input end and the output end; and
the phase lag branch circuit comprises a first phase lag unit, a second phase lag unit, and a second radio frequency switch unit, the first phase lag unit and the second phase lag unit are connected in series between the input end and the output end, and the second radio frequency switch unit is connected between the ground and a first connection point between the first phase lag unit and the second phase lag unit.

2. The phase shift circuit according to claim 1, wherein when the first radio frequency switch unit and the second radio frequency switch unit are in an on state, a phase of a radio frequency signal output by the output end leads a phase of a radio frequency signal input by the input end.

3. The phase shift circuit according to either of claims 1 and 2, wherein when the first radio frequency switch unit and the second radio frequency switch unit are in an off state, the phase of the radio frequency signal output by the output end lags behind the phase of the radio frequency signal input by the input end.

4. The phase shift circuit according to any one of claims 1 to 3, wherein the phase lead unit comprises a first inductive unit, and the first inductive unit and the first radio frequency switch unit are connected in series between the input end and the output end.

5. The phase shift circuit according to any one of claims 1 to 3, wherein the phase lead unit comprises a first capacitive unit, and the first capacitive unit and the first radio frequency switch unit are connected in series between the input end and the output end.

6. The phase shift circuit according to claim 5, wherein the phase lead unit further comprises a second inductive unit, one end of the second inductive unit is connected to a second connection point, the other end of the second inductive unit is grounded, and the second connection point is a connection point between the first radio frequency switch unit and the first capacitive unit.

7. The phase shift circuit according to either of claims 5 and 6, wherein the phase lead branch circuit further comprises a third inductive unit, and the third inductive unit and the first capacitive unit are connected in parallel.

8. The phase shift circuit according to any one of claims 1 to 7, wherein the phase lag branch circuit further comprises a third phase lag unit; and
the third phase lag unit and the second radio frequency switch unit are connected in series between the first connection point and the ground.

9. The phase shift circuit according to claim 8, wherein the phase lag branch circuit further comprises a second capacitive unit; and
the second capacitive unit, the third phase lag unit, and the second radio frequency switch unit are connected in series between the first connection point and the ground.

10. The phase shift circuit according to claim 9, wherein the phase lag branch circuit further comprises a fourth inductive unit, and the fourth inductive unit and the second capacitive unit are connected in parallel.

11. The phase shift circuit according to any one of claims 1 to 7, wherein the phase lag branch circuit further comprises a third capacitive unit; and
the third capacitive unit and the second radio frequency switch unit are connected in series between the first connection point and the ground.

12. The phase shift circuit according to claim 10, wherein the phase lag branch circuit further comprises a fifth inductive unit, and the fifth inductive unit is connected in parallel to the third capacitive unit.

13. An antenna system, wherein the antenna system comprises an antenna unit and the phase shift circuit according to any one of claims 1 to 12, and the phase shift circuit is connected to the antenna unit.

14. A communication device, wherein the communication device comprises a digital intermediate frequency unit, a radio frequency unit connected to the digital intermediate frequency unit, and an antenna unit, the radio frequency unit comprises the phase shift circuit according to claims 1 to 12, and the phase shift circuit is connected to the antenna unit.
